# EUROPEAN PATENT APPLICATION

(11) **EP 4 761 492 A1**
(43) Date of publication of application: **17.06.2026**
(21) Application number: 24864555.8
(22) Date of filing: 06.09.2024
(51) Int. Cl.: H10B 10/00

(54) **CHIP, ELECTRONIC DEVICE AND CHIP MANUFACTURING METHOD**

(30) Priority: 13.09.2023 CN 202311184415
(71) Applicant: HUAWEI TECHNOLOGIES CO., LTD., Shenzhen 518129 (CN)
(72) Inventor: ZHAN, Shijie, Shenzhen, Guangdong 518129 (CN); WU, Ying, Shenzhen, Guangdong 518129 (CN); JING, Weiliang, Shenzhen, Guangdong 518129 (CN); YIN, Shihui, Shenzhen, Guangdong 518129 (CN); JIN, Ming, Shenzhen, Guangdong 518129 (CN); WEI, Qingsong, Shenzhen, Guangdong 518129 (CN)
(74) Representative: Grünecker Patent- und Rechtsanwälte PartG mbB
(86) International application number: PCT/CN2024/117563
(87) International publication number: WO 2025/055835

(57) **Abstract**

A chip, an electronic device, and a chip manufacturing method are provided, to resolve a problem of a large area of a chip. In the chip, a pull-up transistor is disposed at a component layer, and the component layer is manufactured by using a front-end-of-line process. A pull-down transistor and a passgate transistor are disposed at a metal interconnection layer, and the metal interconnection layer is manufactured by using a back-end-of-line process. In comparison with a case in which the pull-up transistor, the passgate transistor, and the pull-down transistor are all manufactured by using the front-end-of-line process, a quantity of components manufactured by using the front-end-of-line process can be reduced, an area of the component layer is reduced, and the area of the chip is further reduced.

## Description

This application claims priority to Chinese Patent Application No. 202311184415.4, filed with the China National Intellectual Property Administration on September 13, 2023 and entitled "CHIP, ELECTRONIC DEVICE, AND CHIP MANUFACTURING METHOD", which is incorporated herein by reference in its entirety.

### TECHNICAL FIELD

Embodiments of this application relate to the field of storage device technologies, and specifically, to a chip, an electronic device, and a chip manufacturing method.

### BACKGROUND

A cache (cache) is a storage device between a processor (such as a Central Processing Unit, CPU for short) and a memory in a chip, and generally includes a static random access memory (SRAM). The memory and a logic circuit in the chip are manufactured by using a front-end-of-line process, resulting in a large area of the chip.

### SUMMARY

Embodiments of this application provide a chip, an electronic device, and a chip manufacturing method, to reduce an area of a chip.

According to a first aspect, an embodiment of this application provides a chip, including a substrate, a component layer, and a metal interconnection layer. The component layer is disposed on the substrate, the component layer includes a logic circuit, and the component layer is configured to be manufactured by using a front-end-of-line process. The metal interconnection layer is stacked on a side that is of the component layer and that is away from the substrate, and the metal interconnection layer is configured to be manufactured by using a back-end-of-line process. The chip further includes a static random access memory. The static random access memory includes a passgate transistor, a pull-up transistor, and a pull-down transistor, the pull-up transistor is disposed at the component layer, and the passgate transistor and the pull-down transistor are disposed at the metal interconnection layer.

Through the foregoing arrangement, the pull-up transistor is disposed at the component layer, and the component layer is manufactured by using the front-end-of-line process. The pull-down transistor and the passgate transistor are disposed at the metal interconnection layer, and the metal interconnection layer is manufactured by using the back-end-of-line process. In comparison with a case in which the pull-up transistor, the passgate transistor, and the pull-down transistor are all manufactured by using the front-end-of-line process, a quantity of components manufactured by using the front-end-of-line process can be reduced, an area of the component layer is reduced, and an area of the chip is further reduced.

In some embodiments that may include the foregoing embodiment, the pull-up transistor includes a P-type transistor, and the passgate transistor and the pull-down transistor are N-type transistors. An oxide semiconductor transistor manufactured by using the back-end-of-line process is more easily manufactured as an N-type transistor, and the passgate transistor and the pull-down transistor that are manufactured by using the back-end-of-line process are the N-type transistors. This can facilitate manufacturing of the passgate transistor and the pull-down transistor.

In some embodiments that may include the foregoing embodiment, a material of the substrate includes silicon, and the pull-up transistor includes a silicon field-effect transistor. Through such arrangement, this further facilitates manufacturing of the pull-up transistor. In addition, monocrystalline silicon has high uniformity, which can ensure high performance for the pull-up transistor.

In some embodiments that may include the foregoing embodiment, the metal interconnection layer includes a first metal interconnection layer and a second metal interconnection layer that are stacked, the first metal interconnection layer is located between the second metal interconnection layer and the component layer, and the passgate transistor and the pull-down transistor are disposed at the first metal interconnection layer and the second metal interconnection layer. Through such arrangement, in comparison with that the passgate transistor and the pull-down transistor are disposed at the first metal interconnection layer or the second metal interconnection layer, areas of the static random access memory and the chip can be reduced.

In some embodiments that may include the foregoing embodiment, the passgate transistor includes a first passgate transistor and a second passgate transistor, the pull-up transistor includes a first pull-up transistor and a second pull-up transistor, and the pull-down transistor includes a first pull-down transistor and a second pull-down transistor. The static random access memory includes a memory cell, the memory cell is configured to store data, the memory cell is a 6T memory cell, and the memory cell includes: the first passgate transistor, the second passgate transistor, the first pull-up transistor, the second pull-up transistor, the first pull-down transistor, and the second pull-down transistor. Through such arrangement, a total of 6 transistors: the first passgate transistor, the second passgate transistor, the first pull-up transistor, the second pull-up transistor, the first pull-down transistor, and the second pull-down transistor, form the memory cell for data storage. The first pull-up transistor and the first pull-down transistor form a first inverter, the second pull-up transistor and the second pull-down transistor form a second inverter, an output end of the first inverter is connected to an input of the second inverter to form a first storage node, an output end of the second inverter is electrically connected to an input of the first inverter to form a second storage node, and the first inverter and the second inverter form a latch circuit.

In some embodiments that may include the foregoing embodiment, one electrode of the first pull-up transistor and one electrode of the second pull-up transistor are connected to a first power supply line, the other electrode of the first pull-up transistor is connected to a gate of the second pull-up transistor, and the other electrode of the second pull-up transistor is connected to a gate of the first pull-up transistor. The gate of the first pull-up transistor is further connected to one electrode of the second pull-down transistor, the other electrode of the second pull-down transistor is connected to a second power supply line, a gate of the second pull-down transistor is further connected to the gate of the second pull-up transistor, one electrode of the first pull-down transistor is connected to the gate of the second pull-up transistor, the other electrode of the first pull-down transistor is connected to the second power supply line, and a gate of the first pull-down transistor is connected to the gate of the first pull-up transistor. The gate of the first pull-down transistor is further connected to one electrode of the second passgate transistor, the other electrode of the second passgate transistor is connected to a bit line bar, and a gate of the second passgate transistor is connected to a word line. One electrode of the first passgate transistor is connected to the gate of the second pull-down transistor, the other electrode of the first passgate transistor is connected to a bit line, and a gate of the first passgate transistor is also connected to the word line.

In some embodiments that may include the foregoing embodiment, the first passgate transistor and the second passgate transistor are located at the second metal interconnection layer, and the first pull-down transistor and the second pull-down transistor are located at the first metal interconnection layer. Through such arrangement, it can be ensured that there are no excessive transistors at the first metal interconnection layer and the second metal interconnection layer, thereby avoiding excessively complex structures of the first metal interconnection layer and the second metal interconnection layer.

In some embodiments that may include the foregoing embodiment, in the same memory cell, the gate of the first pull-up transistor and the gate of the second pull-up transistor are disposed in parallel and spaced apart, the gate of the first pull-up transistor extends towards the second pull-up transistor, the gate of the first pull-up transistor is connected to an electrode of the second pull-up transistor via a first contact structure, the gate of the second pull-up transistor extends towards the first pull-up transistor, and the gate of the second pull-up transistor is connected to an electrode of the first pull-up transistor via a second contact structure. Through such arrangement, the first pull-up transistor and the second pull-up transistor form a roughly center-rotated symmetric structure, and a symmetric center may be a center of a connection line between a midpoint of the gate of the first pull-up transistor and a midpoint of the gate of the second pull-up transistor.

In some embodiments that may include the foregoing embodiment, the gate of the first pull-down transistor and the gate of the second pull-down transistor are disposed in parallel and spaced apart, one end that is of the gate of the first pull-down transistor and that is close to the second pull-down transistor is connected to an electrode of the second pull-down transistor via a third contact structure, and one end that is of the gate of the second pull-down transistor and that is close to the first pull-down transistor is connected via a fourth contact structure. Through such arrangement, the first pull-down transistor and the second pull-down transistor form a roughly center-rotated symmetric structure, and a symmetric center of the structure may be a center of a connection line between a midpoint of the gate of the first pull-down transistor and a midpoint of the gate of the second pull-down transistor.

In some embodiments that may include the foregoing embodiment, an electrode of the first passgate transistor is connected to the fourth contact structure via a sixth contact structure, the fourth contact structure is further connected to the second contact structure, and the first storage node includes the sixth contact structure, the fourth contact structure, and the second contact structure. An electrode of the second passgate transistor is connected to the third contact structure via a seventh contact structure, the third contact structure is further connected to the first contact structure, and the second storage node includes the seventh contact structure, the third contact structure, and the first contact structure.

In some embodiments that may include the foregoing embodiment, in each memory cell, the gate of the first passgate transistor and the gate of the second passgate transistor extend in a same direction at the second metal interconnection layer, so that the gate of the first passgate transistor and the gate of the second passgate transistor are disposed in parallel and spaced apart. In this way, the first passgate transistor and the second passgate transistor form a roughly centrosymmetric structure. A symmetric center may be a center of a connection line between a midpoint of the gate of the first passgate transistor and a midpoint of the gate of the second passgate transistor.

In some embodiments that may include the foregoing embodiment, gates of first passgate transistors in a plurality of memory cells are of an integrated structure, gates of second passgate transistors in the plurality of memory cells are of an integrated structure, and in the plurality of memory cells, a gate of at least one first passgate transistor and a gate of at least one second passgate transistor are connected, and are connected to a word line. Through such arrangement, the gates of the first passgate transistors and the gates of the second passgate transistors in the plurality of memory cells are connected to the word line, so that a connection structure can be simplified.

In some embodiments that may include the foregoing embodiment, in the same memory cell, the gate of the first passgate transistor and the gate of the second passgate transistor are disposed in parallel and spaced apart, a first connection portion is further disposed at the second metal interconnection layer, one end that is of the gate of the first passgate transistor and that is close to the second passgate transistor is connected, via the first connection portion, to one end that is of the gate of the second passgate transistor and that is close to the first passgate transistor, and the first connection portion is connected to a word line. Through such arrangement, a gate of a first passgate transistor and a gate of a second passgate transistor in each memory cell are connected to the word line via the corresponding first connection portion. In comparison with the gates of the first passgate transistors and the gates of the second passgate transistors in the plurality of memory cells that are connected to the word line via a same fifth contact structure, parasitic resistance of the word line can be reduced, and a signal transmission response speed of the word line can be improved.

In some embodiments that may include the foregoing embodiment, in the same memory cell, a gate of the first passgate transistor and a gate of the second passgate transistor are of an integrated structure, a second connection portion is further disposed at the second metal interconnection layer, the second connection portion is located between the first passgate transistor and the second passgate transistor, the second connection portion is connected to the gate of the first passgate transistor, and the second connection portion is connected to a word line. Through such arrangement, the gate of the first passgate transistor and the gate of the second passgate transistor are of the integrated structure. This can simplify a structure of the chip and facilitate manufacturing of the chip. In addition, a gate of a first passgate transistor and a gate of a second passgate transistor in each memory cell are connected to the word line via one second connection portion, which can reduce parasitic resistance.

In some embodiments that may include the foregoing embodiment, the word line is disposed on a side that is at the second metal interconnection layer and that is away from the substrate. Through such arrangement, this facilitates the connection between the word line, and the first passgate transistor and the second passgate transistor.

In some embodiments that may include the foregoing embodiment, the first passgate transistor and the first pull-down transistor are located at the first metal interconnection layer, and the second passgate transistor and the second pull-down transistor are located at the second metal interconnection layer. Through such arrangement, this can avoid excessively complex structures of the first metal interconnection layer and the second metal interconnection layer.

In some embodiments that may include the foregoing embodiment, an electrode of the first passgate transistor and an electrode of the first pull-down transistor that are close to each other are of an integrated structure, and an electrode of the second passgate transistor and an electrode of the second pull-down transistor that are close to each other are of an integrated structure. Through such arrangement, there is no need to additionally dispose another structure used to connect one electrode of the first passgate transistor and one electrode of the first pull-down transistor, thereby simplifying the structure of the chip. In addition, the electrode of the first passgate transistor and the electrode of the first pull-down transistor are of the integrated structure, and the electrode of the first passgate transistor and the electrode of the first pull-down transistor may be formed at the same time by using a same process, thereby facilitating manufacturing of the chip. Similarly, there is no need to additionally dispose another structure used to connect one electrode of the second passgate transistor and one electrode of the second pull-down transistor, thereby simplifying the structure of the chip. In addition, the electrode of the second passgate transistor and the electrode of the second pull-down transistor are of the integrated structure, and the electrode of the second passgate transistor and the electrode of the second pull-down transistor may be formed at the same time by using a same process, thereby facilitating manufacturing of the chip.

In some embodiments that may include the foregoing embodiment, the metal interconnection layer includes a plurality of first dielectric layers and a plurality of second dielectric layers that are alternately stacked, and a dielectric constant of the first dielectric layer is less than a dielectric constant of the second dielectric layer. In other words, the first dielectric layer is made of a low-dielectric-constant material. Through such arrangement, parasitic capacitance of the chip can be reduced, thereby improving performance of the chip. In addition, because a dielectric constant of the first dielectric layer is small, an anti-etching capability of the first dielectric layer is poor (etch selectivity is high). The first dielectric layer and the second dielectric layer are alternately stacked, and etch selectivity of the first dielectric layer and the second dielectric layer is different, so that the metal interconnection layer can be easily etched, thereby facilitating manufacturing of the chip.

According to a second aspect, an embodiment of this application further provides an electronic device, including a mainboard and the foregoing chip. The chip is disposed on the mainboard.

The electronic device provided in this embodiment of this application includes the chip in any one of the foregoing embodiments. Therefore, the electronic device and the chip can resolve a same technical problem and achieve same technical effect.

According to a third aspect, an embodiment of this application further provides a chip manufacturing method, including:
manufacturing, by using a front-end-of-line process on a substrate, a component layer and a pull-up transistor located at the component layer, where the component layer includes a logic circuit; and forming, by using a back-end-of-line process in a stacked manner on the component layer, a metal interconnection layer, and a passgate transistor and a pull-down transistor that are located at the metal interconnection layer, where a static random access memory includes the passgate transistor, the pull-up transistor, and the pull-down transistor.

In some embodiments that may include the foregoing embodiment, forming, by using the back-end-of-line process in the stacked manner on the component layer, the metal interconnection layer, and the passgate transistor and the pull-down transistor that are located at the metal interconnection layer includes: forming a first metal interconnection layer and a second metal interconnection layer by using the back-end-of-line process in the stacked manner on the component layer. The first metal interconnection layer is located between the second metal interconnection layer and the component layer, and the passgate transistor and the pull-down transistor are disposed at the first metal interconnection layer and the second metal interconnection layer. Through such arrangement, in comparison with that the passgate transistor and the pull-down transistor are disposed at the first metal interconnection layer or the second metal interconnection layer, areas of the static random access memory and the chip can be reduced.

In some embodiments that may include the foregoing embodiment, the passgate transistor includes a first passgate transistor and a second passgate transistor, the pull-up transistor includes a first pull-up transistor and a second pull-up transistor, and the pull-down transistor includes a first pull-down transistor and a second pull-down transistor. The static random access memory includes a memory cell, the memory cell is configured to store data, the memory cell is a 6T memory cell, and the memory cell includes: the first passgate transistor, the second passgate transistor, the first pull-up transistor, the second pull-up transistor, the first pull-down transistor, and the second pull-down transistor. Forming the first metal interconnection layer and the second metal interconnection layer by using the back-end-of-line process in the stacked manner on the component layer includes: forming, by using the back-end-of-line process in the stacked manner on the component layer, the first metal interconnection layer, and the first pull-down transistor and the second pull-down transistor that are located at the first metal interconnection layer; and forming, by using the back-end-of-line process in the stacked manner on the first metal interconnection layer, the second metal interconnection layer, and the first passgate transistor and the second passgate transistor that are located at the second metal interconnection layer. Through such arrangement, it can be ensured that there are no excessive transistors at the first metal interconnection layer and the second metal interconnection layer, thereby avoiding excessively complex structures of the first metal interconnection layer and the second metal interconnection layer.

In some embodiments that may include the foregoing embodiment, the passgate transistor includes a first passgate transistor and a second passgate transistor, the pull-up transistor includes a first pull-up transistor and a second pull-up transistor, and the pull-down transistor includes a first pull-down transistor and a second pull-down transistor. The static random access memory includes a memory cell, the memory cell is configured to store data, the memory cell is a 6T memory cell, and the memory cell includes: the first passgate transistor, the second passgate transistor, the first pull-up transistor, the second pull-up transistor, the first pull-down transistor, and the second pull-down transistor. Forming the first metal interconnection layer and the second metal interconnection layer by using the back-end-of-line process in the stacked manner on the component layer includes: forming, by using the back-end-of-line process in the stacked manner on the component layer, the first metal interconnection layer, and the first pull-down transistor and the first passgate transistor that are located at the first metal interconnection layer; and forming, by using the back-end-of-line process in the stacked manner on the first metal interconnection layer, the second metal interconnection layer, and the second pull-down transistor and the second passgate transistor that are located at the second metal interconnection layer. Through such arrangement, it can be ensured that there are no excessive transistors at the first metal interconnection layer and the second metal interconnection layer, thereby avoiding excessively complex structures of the first metal interconnection layer and the second metal interconnection layer.

For a chip manufactured according to the chip manufacturing method provided in this embodiment of this application, the pull-up transistor is disposed at the component layer, and the component layer is manufactured by using the front-end-of-line process. The pull-down transistor and the passgate transistor are disposed at the metal interconnection layer, and the metal interconnection layer is manufactured by using the back-end-of-line process. In comparison with a case in which the pull-up transistor, the passgate transistor, and the pull-down transistor are all manufactured by using the front-end-of-line process, a quantity of components manufactured by using the front-end-of-line process can be reduced, the area of the component layer is reduced, and the area of the chip is further reduced.

### BRIEF DESCRIPTION OF DRAWINGS

FIG. 1 is a sectional view of a chip according to an embodiment of this application;
FIG. 2 is a circuit diagram in which in a chip, passgate transistors are disposed at a same layer and pull-down transistors are disposed at a same layer according to an embodiment of this application;
FIG. 3 is a diagram of a connection between a chip and a static random access memory in a related technology;
FIG. 4 is a top view of a component layer obtained when in a chip, passgate transistors are disposed at a same layer and pull-down transistors are disposed at a same layer according to an embodiment of this application;
FIG. 5 is an exploded diagram in which in a chip, passgate transistors are disposed at a same layer and pull-down transistors are disposed at a same layer according to an embodiment of this application;
FIG. 6 is a top view of a first metal interconnection layer obtained when in a chip, passgate transistors are disposed at a same layer and pull-down transistors are disposed at a same layer according to an embodiment of this application;
FIG. 7 is an enlarged diagram for a dashed line box in FIG. 6;
FIG. 8 is a top view of a second metal interconnection layer obtained when in a chip, passgate transistors are disposed at a same layer and pull-down transistors are disposed at a same layer according to an embodiment of this application;
FIG. 9 is an enlarged diagram for a dashed line box in FIG. 8;
FIG. 10 is a sectional view of FIG. 7 and FIG. 9 in an A-A direction;
FIG. 11 is a sectional view of FIG. 8 in a B-B direction;
FIG. 12 is a top view of a second metal interconnection layer obtained when a memory cell in a chip includes 8 transistors according to an embodiment of this application;
FIG. 13 is a top view of a third metal interconnection layer obtained when a memory cell in a chip includes 8 transistors according to an embodiment of this application;
FIG. 14 is a circuit diagram in which a memory cell in a chip includes 8 transistors according to an embodiment of this application;
FIG. 15 is a top view of a second metal interconnection layer obtained when a gate of a first passgate transistor and a gate of a second passgate transistor in a chip are connected via a first connection portion according to an embodiment of this application;
FIG. 16 is an enlarged diagram for a dashed line box in FIG. 15;
FIG. 17 is a sectional view of FIG. 16 in a C-C direction;
FIG. 18 is a sectional view of FIG. 16 in a D-D direction;
FIG. 19 is a top view of a first metal interconnection layer obtained when a gate of a first passgate transistor and a gate of a second passgate transistor in a chip are of an integrated structure according to an embodiment of this application;
FIG. 20 is a top view of a second metal interconnection layer obtained when a gate of a first passgate transistor and a gate of a second passgate transistor in a chip are of an integrated structure according to an embodiment of this application;
FIG. 21 is a sectional view of FIG. 20 in an E-E direction;
FIG. 22 is a top view of a first metal interconnection layer obtained when a passgate transistor and a pull-down transistor in a chip are disposed at a same layer according to an embodiment of this application;
FIG. 23 is a top view of a second metal interconnection layer obtained when a passgate transistor and a pull-down transistor in a chip are disposed at a same layer according to an embodiment of this application;
FIG. 24 is a sectional view of FIG. 22 and FIG. 23 in an F-F direction;
FIG. 25 is a circuit diagram in which a passgate transistor and a pull-down transistor in a chip are disposed at a same layer according to an embodiment of this application; and
FIG. 26 is a block diagram of a chip according to an embodiment of this application.

Reference numerals:
1: substrate; 10: core region; 20: peripheral region; 30: component layer; 40: metal interconnection layer; 41: first metal interconnection layer; 42: second metal interconnection layer; 43: gate; 110: chip; 120: static random access memory; 130: static random access memory; 140: logic circuit; 302: first conductive structure; 303: first conductive portion; 304: second conductive portion; 305: third dielectric layer; 306: fourth dielectric layer; 307: first contact structure; 308: second contact structure; 401: first dielectric layer; 402: second dielectric layer; 404: first connection portion; 407: second conductive structure; 408: third contact structure; 409: fourth contact structure; 410: third conductive structure; 411: sixth contact structure; and 412: seventh contact structure.

### DESCRIPTION OF EMBODIMENTS

The following describes the technical solutions in embodiments of this application with reference to the accompanying drawings in embodiments of this application. It is clear that the described embodiments are merely a part rather than all of embodiments of this application.

In the following description, the terms "first", "second", and the like are merely intended for a purpose of description, and shall not be understood as indicating or implying relative importance or implying a quantity of indicated technical features. Therefore, a feature limited by "first", "second", or the like may explicitly or implicitly include one or more features.

In addition, in embodiments of this application, orientation terms such as "above", "below", "left", "right", "horizontal", and "vertical" are defined relative to placement orientations of components shown in the accompanying drawings. It should be understood that these directional terms are relative concepts that are used for relative description and clarification, and may vary correspondingly based on changes in the placement orientations of the components in the accompanying drawings.

In embodiments of this application, unless otherwise clearly specified and limited, a term "connection" should be understood in a broad sense. For example, the "connection" may be a fastened connection, an electrical connection, a coupling connection, a detachable connection, or an integral connection, may be a direct connection, or an indirect connection implemented through an intermediate medium. The coupling may be understood as direct coupling and/or indirect coupling, and the "coupling connection" may be understood as a direct coupling connection and/or an indirect coupling connection.

An embodiment of this application provides an electronic device. The electronic device may include a computer, a mobile phone, a server, and the like. The electronic device includes a mainboard and a chip disposed on the mainboard. The chip is electrically connected to a circuit on the mainboard. The chip may perform data processing, computing, and the like. The chip may be a central processing unit (Central Processing Unit, CPU for short).

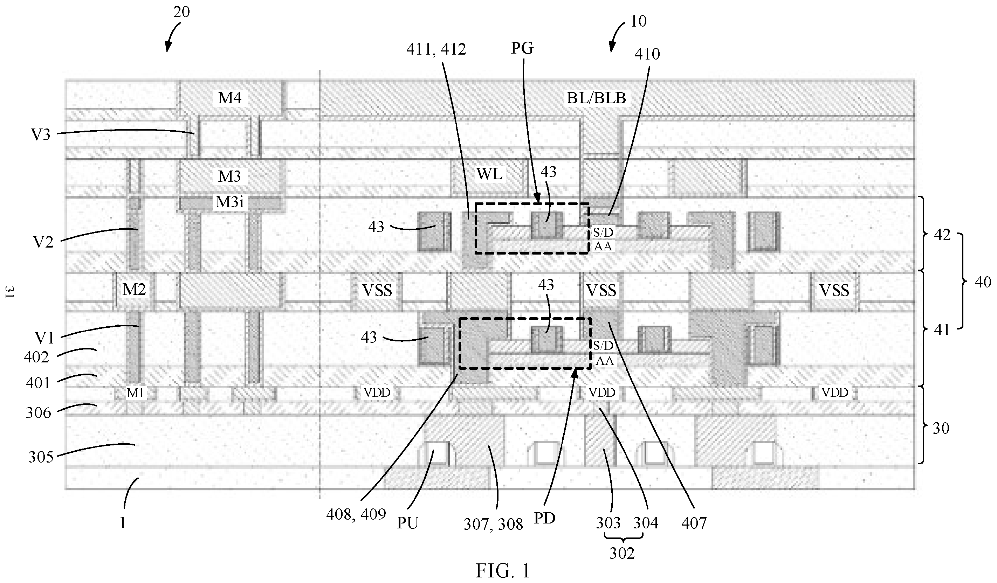

Refer to FIG. 1. In this embodiment of this application, the chip includes a substrate 1 and a component layer 30 disposed on the substrate 1. The substrate 1 may be used as a basis of the chip, and is configured to carry a film layer structure such as the component layer 30. For example, a material of the substrate 1 may include silicon, germanium, and the like. The material of the substrate 1 is not limited in this embodiment of this application. The component layer 30 includes a logic circuit, and the logic circuit may be configured to perform data processing, computing, and the like.

In the foregoing implementation, the chip further includes a metal interconnection layer 40. The metal interconnection layer 40 is stacked on a side that is of the component layer 30 and that is away from the substrate 1. The metal interconnection layer 40 is configured to be manufactured by using a back-end-of-line process, and the component layer 30 is configured to be manufactured by using a front-end-of-line process. It may be understood that during manufacturing, the component layer 30 and the logic circuit at the component layer 30 may be first manufactured by using the front-end-of-line process, and then the metal interconnection layer 40 is manufactured on the component layer 30 by using the back-end-of-line process. For example, the metal interconnection layer 40 may include a plurality of first dielectric layers 401 and a plurality of second dielectric layers 402 that are alternately stacked, and materials of the first dielectric layer 401 and the second dielectric layer 402 may include silicon oxide, silicon nitride, and the like.

In some embodiments, a dielectric constant of the first dielectric layer 401 is smaller than a dielectric constant of the second dielectric layer 402. In other words, the first dielectric layer 401 is made of a low-dielectric-constant material. Through such arrangement, parasitic capacitance of the chip can be reduced, thereby improving performance of the chip. In addition, because the dielectric constant of the first dielectric layer 401 is small, an anti-etching capability of the first dielectric layer 401 is poor (etch selectivity is high). The first dielectric layer 401 and the second dielectric layer 402 are alternately stacked, and etch selectivity of the first dielectric layer 401 and the second dielectric layer 402 is different, so that the metal interconnection layer 40 can be easily etched, thereby facilitating manufacturing of the chip.

In some embodiments, the chip may further include at least one metal layer. The metal layer may be disposed on the first dielectric layer 401 or the second dielectric layer 402, and/or the metal is disposed at the component layer 30, and/or the metal layer is disposed on a side that is of the metal interconnection layer 40 and that is away from the substrate 1. A metal trace may be formed by performing a patterning process on the metal layer, to facilitate a connection on a circuit.

It may be understood that, in this embodiment of this application, the logic circuit may also be disposed at the metal interconnection layer 40, so that the logic circuit is not centralized at the component layer 30. In addition, density of the logic circuit may be increased to improve a data computing and processing capability of the chip.

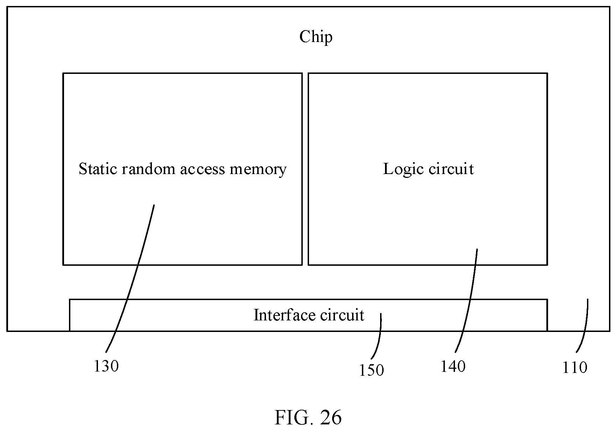

As shown in FIG. 26, the chip 110 in this embodiment of this application further includes a static random access memory 130 (Static Random Access Memory, SRAM for short). The static random access memory 130 may be used as a cache (cache). The static random access memory 130 is a memory between the logic circuit 140 and a memory, and is configured to temporarily store data of the logic circuit 140. The chip 110 further includes an interface circuit 150 connected to the static random access memory 130 and the logic circuit 140. The interface circuit 150 is configured to connect to an external device. For example, in an implementation in which the chip 110 is the central processing unit, the interface circuit 150 may be electrically connected to the circuit on the mainboard, to connect the chip 110 to the mainboard.

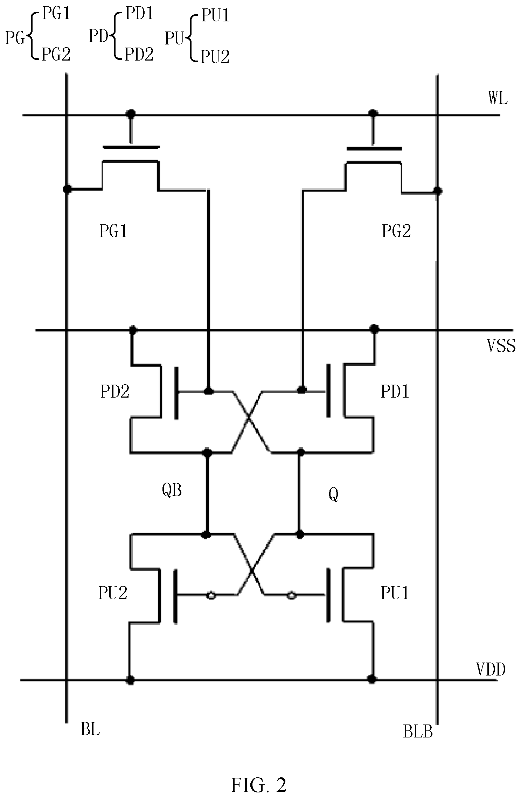

As shown in FIG. 2, in some embodiments, the static random access memory includes a memory cell. The memory cell is configured to store data, and the memory cell may include a passgate transistor PG, a pull-up transistor PU, and a pull-down transistor PD. The passgate transistor PG may include a first passgate transistor PG1 and a second passgate transistor PG2, the pull-up transistor PU may include a first pull-up transistor PU1 and a second pull-up transistor PU2, and the pull-down transistor PD may include a first pull-down transistor PD1 and a second pull-down transistor PD2.

For example, one electrode (source or drain) of the first pull-up transistor PU1 and one electrode of the second pull-up transistor PU2 are connected to a first power supply line VDD, the other electrode (source or drain) of the first pull-up transistor PU1 is connected to a gate of the second pull-up transistor PU2, and the other electrode (source or drain) of the second pull-up transistor PU2 is connected to a gate of the first pull-up transistor PU1. The gate of the first pull-up transistor PU1 is further connected to one electrode of the second pull-down transistor PD2, the other electrode of the second pull-down transistor PD2 is connected to a second power supply line VSS, a gate of the second pull-down transistor PD2 is further connected to the gate of the second pull-up transistor PU2, one electrode of the first pull-down transistor PD1 is connected to the gate of the second pull-up transistor PU2, the other electrode of the first pull-down transistor PD1 is connected to the second power supply line VSS, and a gate of the first pull-down transistor PD1 is connected to the gate of the first pull-up transistor PU1. The gate of the first pull-down transistor PD1 is further connected to one electrode of the second passgate transistor PG2, the other electrode of the second passgate transistor PG2 is connected to a bit line bar BLB, and a gate of the second passgate transistor PG2 is connected to a word line WL. One electrode of the first passgate transistor PG1 is connected to the gate of the second pull-down transistor PD2, the other electrode of the first passgate transistor PG1 is connected to a bit line BL, and a gate of the first passgate transistor PG1 is also connected to the word line WL. A total of 6 transistors: the first passgate transistor PG1, the second passgate transistor PG2, the first pull-up transistor PU1, the second pull-up transistor PU2, the first pull-down transistor PD1, and the second pull-down transistor PD2 form a 6T memory cell (6T SRAM) for data storage. The first pull-up transistor PU1 and the first pull-down transistor PD1 form a first inverter, the second pull-up transistor PU2 and the second pull-down transistor PD2 form a second inverter, an output end of the first inverter is connected to an input of the second inverter to form a first storage node Q, an output end of the second inverter is electrically connected to an input of the first inverter to form a second storage node QB, and the first inverter and the second inverter form a latch circuit. In the foregoing implementation, the first power supply line VDD may be configured to be at a high level, and correspondingly, the second power supply line VSS is configured to be grounded. It may be understood that a voltage of the first power supply line VDD may be properly set based on different cases, so that the static random access memory can operate normally.

During data writing, for example, data stored in the memory cell is "0" in an initial state. In this case, the second storage node QB may be at a high level (storing "1"), the first storage node Q is at a low level (storing "0"), the second pull-down transistor PD2 and the first pull-up transistor PU1 are cut off, and the first pull-down transistor PD1 and the second pull-up transistor PU2 are conducted. The word line WL and the bit line BL are set to high levels, and the bit line bar BLB is set to a low level, so that the first passgate transistor PG1 and the second passgate transistor PG2 are conducted. The bit line BL charges the first storage node Q via the first passgate transistor PG1, and the bit line bar BLB discharges the second storage node QB via the second passgate transistor PG2, so that the second storage node QB is at a low level and the first storage node Q is at a high level, thereby completing writing of "1".

During data reading, the bit line BL and the bit line bar BLB are in a high level state. When the word line WL corresponding to the memory cell is at a high level, the first passgate transistor PG1 and the second passgate transistor PG2 are conducted. In this case, it is equivalent to that the first storage node Q is connected to the bit line BL, and the second storage node QB is connected to the bit line bar BLB. When "1" is read, it is assumed that the first storage node Q stores "1", the second pull-down transistor PD2 and the first pull-up transistor PU1 are conducted, the first pull-down transistor PD1 and the second pull-up transistor PU2 are cut off, the bit line BL still maintains the original high level state, and the bit line bar BLB discharges through a path constituted by the second passgate transistor PG2 and the second pull-down transistor PD2. In this way, a voltage difference is formed between the bit line BL and the bit line bar BLB, thereby completing reading of the data "1".

It may be understood that, in embodiments of this application, a quantity of transistors in the memory cell is not limited to 6. For example, the quantity of transistors in the memory cell may alternatively be 8, 10, or the like. A quantity of transistors that constitute the memory cell is not limited in embodiments of this application.

It may be understood that, in the foregoing implementation, the word line WL, the bit line BL, the bit line bar BLB, the first power supply line VDD, and the second power supply line VSS may be disposed at at least one metal layer. In other words, the word line WL, the bit line BL, the bit line bar BLB, the first power supply line VDD, and the second power supply line VSS may be obtained by performing patterning processing on the at least one metal layer. Locations of the word line WL, the bit line BL, the bit line bar BLB, the first power supply line VDD, and the second power supply line VSS are not limited in embodiments of this application.

Still refer to FIG. 1. In some embodiments, the component layer 30 may further include a first metal layer M1, and the first metal layer M1 may be disposed close to the metal interconnection layer 40. The pull-up transistor PU is disposed at the component layer 30. For example, the first power supply line VDD may be disposed at the component layer 30. Correspondingly, the first power supply line VDD may be located at the first metal layer M1. In other words, the first power supply line VDD may be obtained by performing patterning processing on the first metal layer M1, so that the pull-up transistor PU is connected to the first power supply line VDD.

In some embodiments, the pull-up transistor PU includes a P-type transistor, and the passgate transistor PG and the pull-down transistor PD are N-type transistors. An oxide semiconductor transistor manufactured by using the back-end-of-line process is more easily manufactured as an N-type transistor, and the passgate transistor PG and the pull-down transistor PD that are manufactured by using the back-end-of-line process are the N-type transistors. This can facilitate manufacturing of the passgate transistor PG and the pull-down transistor PD.

In an implementation in which the material of the substrate 1 includes silicon, that is, the substrate 1 is a silicon substrate, correspondingly, the pull-up transistor PU may be a silicon field-effect transistor (Si MOSFET), that is, a material of an active region of the pull-up transistor PU may include monocrystalline silicon. Through such arrangement, this further facilitates manufacturing of the pull-up transistor PU. In addition, the monocrystalline silicon has high uniformity, which can ensure high performance for the pull-up transistor PU.

The passgate transistor PG and the pull-down transistor PD are disposed at the metal interconnection layer 40. Correspondingly, the second power supply line VSS may be disposed at the metal interconnection layer 40, so that the pull-down transistor PD is connected to the second power supply line VSS. In some implementations, the bit line BL, the bit line bar BLB, and the word line WL may be disposed on the side that is of the metal interconnection layer 40 and that is away from the substrate 1.

As shown in FIG. 1, according to the chip provided in this embodiment of this application, the component layer 30 is disposed on the substrate 1, the component layer 30 includes the logic circuit, and the component layer 30 is manufactured by using the front-end-of-line process. The metal interconnection layer 40 is stacked on the side that is of the component layer 30 and that is away from the substrate 1, and the metal interconnection layer 40 is manufactured by using the back-end-of-line process. The static random access memory includes the passgate transistor PG, the pull-up transistor PU, and the pull-down transistor PD, the pull-up transistor PU is disposed at the component layer 30, and the passgate transistor PG and the pull-down transistor PD are disposed at the metal interconnection layer 40. Through such arrangement, in comparison with a case in which the pull-up transistor PU, the passgate transistor PG, and the pull-down transistor PD are all manufactured by using the front-end-of-line process, a quantity of components manufactured by using the front-end-of-line process can be reduced, an area of the component layer is reduced, and an area of the chip is further reduced.

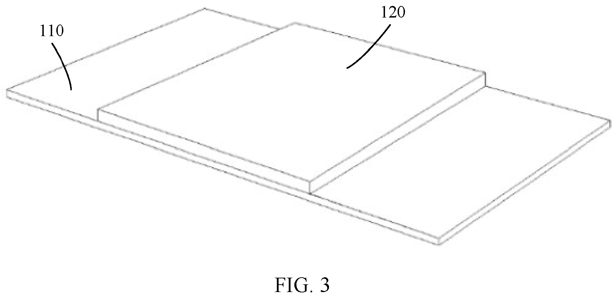

In a related technology shown in FIG. 3, the static random access memory 120 covers the chip 110, and the static random access memory 120 is connected to the chip 110 by using a through silicon via technology. The through silicon via technology needs to be bonded, resulting in a low yield rate. However, in the chip (as shown in FIG. 1) provided in this embodiment of this application, the static random access memory is disposed inside the chip, and the static random access memory is connected to a line in the chip without bonding, thereby improving a yield rate of the chip. In addition, an aperture of a via in the through silicon via technology is large, and a large area of the chip is occupied. However, in a processor in this embodiment of this application, the static random access memory is disposed inside the chip, to avoid occupying surface space of the chip.

As shown in FIG. 1, in some embodiments, the metal interconnection layer 40 includes a first metal interconnection layer 41 and a second metal interconnection layer 42 that are stacked, the first metal interconnection layer 41 is located between the second metal interconnection layer 42 and the component layer 30, and the passgate transistor PG and the pull-down transistor PD are disposed at the first metal interconnection layer 41 and the second metal interconnection layer 42. Through such arrangement, in comparison with that the passgate transistor PG and the pull-down transistor PD are disposed at the first metal interconnection layer 41 or the second metal interconnection layer 42, areas of the static random access memory and the chip can be reduced. In addition, the passgate transistor PG and the pull-down transistor PD are disposed at the first metal interconnection layer 41 and the second metal interconnection layer 42, so that impact on an original back-end-of-line interconnection layer structure can be reduced, thereby further reducing impact on manufacturing difficulty and the performance of the chip due to addition of an additional component.

In this embodiment of this application, the passgate transistor PG and the pull-down transistor PD are disposed at the first metal interconnection layer 41 and the second metal interconnection layer 42. Correspondingly, there may be a plurality of location relationships between the passgate transistor PG and the pull-down transistor PD. The following describes the plurality of scenarios.

### Scenario 1

Still refer to FIG. 1. In this scenario, the passgate transistor PG may be disposed at the second metal interconnection layer 42, and correspondingly, the pull-down transistor PD may be disposed at the first metal interconnection layer 41, to ensure that there are no excessive transistors at the first metal interconnection layer 41 and the second metal interconnection layer 42, thereby avoiding excessively complex structures of the first metal interconnection layer 41 and the second metal interconnection layer 42.

As shown in FIG. 1 and FIG. 2, in an implementation in which the memory cell of the static random access memory includes the 6 transistors, correspondingly, the passgate transistor PG includes the first passgate transistor PG1 and the second passgate transistor PG2, the pull-up transistor PU includes the first pull-up transistor PU1 and the second pull-up transistor PU2, and the pull-down transistor PD includes the first pull-down transistor PD1 and the second pull-down transistor PD2. The first passgate transistor PG1 and the second passgate transistor PG2 may be disposed at the second metal interconnection layer 42, and the first pull-down transistor PD1 and the second pull-down transistor PD2 are disposed at the first metal interconnection layer 41.

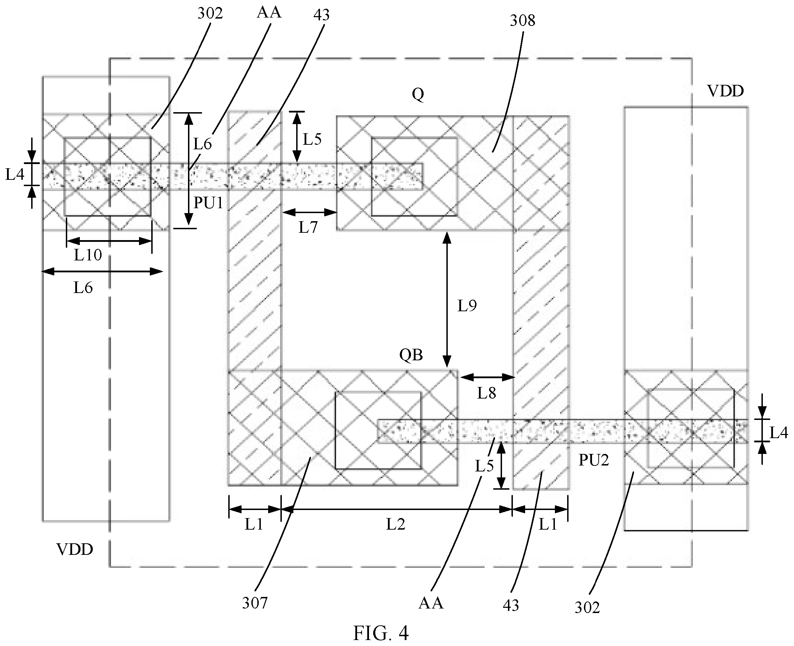

Refer to FIG. 4. In this scenario, the first pull-up transistor PU1 and the second pull-up transistor PU2 are disposed at the component layer 30 shown in FIG. 1. The component layer 30 may include a third dielectric layer 305, a fourth dielectric layer 306, and the first metal layer M1 that are stacked. The fourth dielectric layer 306 is located between the third dielectric layer 305 and the first metal layer M1, and the third dielectric layer 305 is disposed close to the substrate 1. The first pull-up transistor PU1 and the second pull-up transistor PU2 may be disposed at the third dielectric layer 305. The first metal layer M1 may include the first power supply line VDD. Correspondingly, an electrode (source or drain) of the first pull-up transistor PU1 may be connected to the first power supply line VDD via a first conductive structure 302. For example, a first hole may be disposed at the third dielectric layer 305, a hole bottom of the first hole extends to the electrode of the first pull-up transistor PU1, a second hole is disposed at the fourth dielectric layer 306, and the second hole is in communication with the first hole. The first conductive structure 302 may include a first conductive portion 303 and a second conductive portion 304, the first conductive portion 303 is located in the first hole, the second conductive portion 304 is located in the second hole, and the second conductive portion 304 is in contact with the first conductive portion 303 and the first power supply line VDD. In this way, the first pull-up transistor PU1 can be connected to the first power supply line VDD via the first conductive portion 303 and the second conductive portion 304. Similarly, a connection structure between the second pull-up transistor PU2 and the first power supply line VDD is approximately similar to a connection structure between the first pull-up transistor PU1 and the first power supply line VDD. Details are not described herein again.

In some embodiments, the front-end-of-line process may include a process before the fourth dielectric layer 306 is formed. In an implementation in which the substrate 1 includes the monocrystalline silicon, the front-end-of-line process may include a process of processing the monocrystalline silicon to form components such as the logic circuit and the pull-up transistor PU. Correspondingly, the back-end-of-line process may include forming the fourth dielectric layer 306 and a process after the fourth dielectric layer 306 is formed. For example, the back-end-of-line process may include forming the fourth dielectric layer 306, the second conductive portion 304, the first metal layer M1, the pull-up transistor PU, a second metal layer M2, the passgate transistor PG, a third metal layer M3, a fourth metal layer M4, and the like.

In another embodiment, the front-end-of-line process may include forming the fourth dielectric layer 306 and a process before the fourth dielectric layer 306 is formed. In an implementation in which the substrate 1 includes the monocrystalline silicon, for example, the front-end-of-line process may include processing the monocrystalline silicon to form components such as the logic circuit, the pull-up transistor PU, the fourth dielectric layer 306, and the second conductive portion 304. Correspondingly, the back-end-of-line process may include a process after the fourth dielectric layer 306 is formed. For example, the back-end-of-line process may include forming the first metal layer M1, the pull-up transistor PU, the second metal layer M2, the passgate transistor PG, the third metal layer M3, the fourth metal layer M4, and the like.

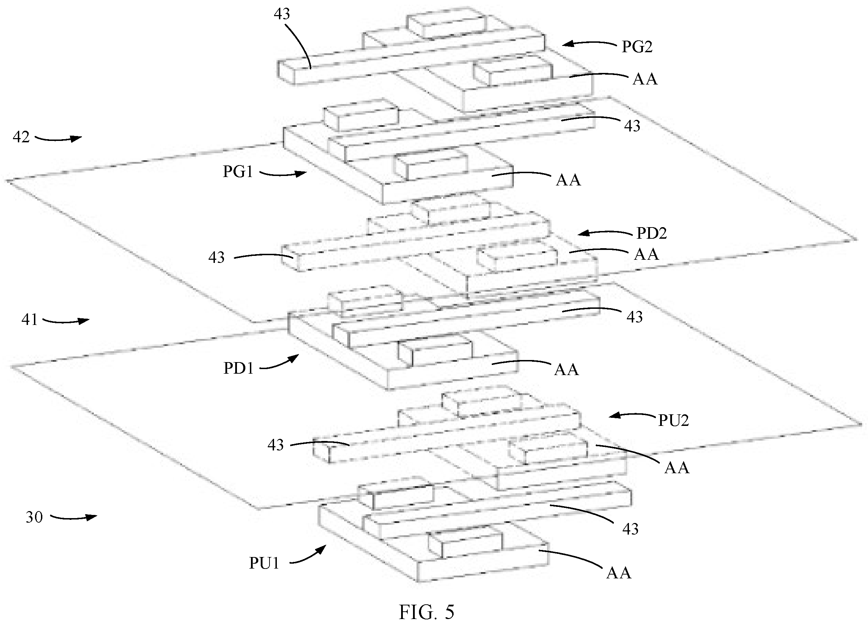

In a same memory cell, a gate 43 of the first pull-up transistor PU1 and a gate 43 of the second pull-up transistor PU2 extend in a same direction (a vertical direction in FIG. 4) at the component layer 30. The gate 43 of the first pull-up transistor PU1 and the gate 43 of the second pull-up transistor PU2 are disposed in parallel and spaced apart, the gate 43 of the first pull-up transistor PU1 extends towards the second pull-up transistor PU2, and the gate 43 of the first pull-up transistor PU1 is connected to the other electrode (source or drain) of the second pull-up transistor PU2 via a first contact structure 307. Similarly, the gate 43 of the second pull-up transistor PU2 extends towards the first pull-up transistor PU1, and the gate 43 of the second pull-up transistor PU2 is connected to the other electrode of the first pull-up transistor PU1 via a second contact structure 308. The first contact structure 307 and the second contact structure 308 may be disposed at the component layer 30, and the first contact structure 307 may be in contact with the gate 43 of the first pull-up transistor PU1 or connected to the gate 43 of the first pull-up transistor PU1 through a conductive hole. The first contact structure 307 may be in contact with the other electrode of the second pull-up transistor PU2 or connected to the other electrode of the second pull-up transistor PU2 through a conductive hole. Certainly, a part of the first contact structure 307 may alternatively be used as the other electrode of the second pull-up transistor PU2, thereby simplifying the structure of the chip. Similarly, the second contact structure 308 may be in contact with the gate 43 of the second pull-up transistor PU2 or connected to the gate 43 of the second pull-up transistor PU2 through the conductive hole. The second contact structure 308 may be in contact with the other electrode of the first pull-up transistor PU1 or connected to the other electrode of the first pull-up transistor PU1 through the conductive hole. Certainly, a part of the second contact structure 308 may alternatively be used as the other electrode of the first pull-up transistor PU1. Through such arrangement, the first pull-up transistor PU1 and the second pull-up transistor PU2 form a roughly center-rotated symmetric structure (as shown in FIG. 5), and a symmetric center may be a center of a connection line between a midpoint of the gate 43 of the first pull-up transistor PU1 and a midpoint of the gate 43 of the second pull-up transistor PU2.

In the foregoing implementation, the gate 43 of the first pull-up transistor PU1 and the gate 43 of the second pull-up transistor PU2 extend in a first direction (a vertical direction in FIG. 4), and widths L1 of the gate 43 of the first pull-up transistor PU1 and the gate 43 of the second pull-up transistor PU2 in a second direction (a horizontal direction in FIG. 4) perpendicular to the first direction are from 5 nm to 100 nm (for example, 5 nm, 50 nm, or 100 nm). A distance L2 between the gate 43 of the first pull-up transistor PU1 and the gate 43 of the second pull-up transistor PU2 in the second direction may be from 20 nm to 200 nm (for example, 20 nm, 100 nm, or 200 nm). An active region AA of the first pull-up transistor PU1 and an active region AA of the second pull-up transistor PU2 extend in the second direction, and widths L4 of the active region AA of the first pull-up transistor PU1 and the active region AA of the second pull-up transistor PU2 in the first direction are from 5 nm to 200 nm (for example, 5 nm, 100 nm, or 200 nm). The gate 43 of the first pull-up transistor PU1 extends in a direction away from the second pull-up transistor PU2, and an exceeding distance L5 to the active region of the first pull-up transistor PU1 is from 5 nm to 50 nm (for example, 5 nm, 10 nm, or 50 nm). The gate 43 of the second pull-up transistor PU2 extends in a direction away from the first pull-up transistor PU1, and an exceeding distance L5 to the active region of the second pull-up transistor PU2 is from 5 nm to 50 nm (for example, 5 nm, 10 nm, or 50 nm). Widths L6 of the first conductive structure 302 in the first direction and the second direction are from 10 nm to 60 nm (for example, 10 nm, 30 nm, or 60 nm). A distance L7 between the gate 43 of the first pull-up transistor PU1 and the second contact structure 308 in the second direction is from 5 nm to 50 nm (for example, 5 nm, 10 nm, or 50 nm), and a distance L8 between the gate 43 of the second pull-up transistor PU2 and the first contact structure 307 in the second direction is from 5 nm to 50 nm (for example, 5 nm, 10 nm, or 50 nm). A distance L9 between the first contact structure 307 and the second contact structure 308 in the first direction is from 20 nm to 100 nm (for example, 20 nm, 50 nm, or 100 nm), a width L10 of the first conductive structure 302 (for example, the second conductive portion 304) in the second direction is from 10 nm to 50 nm (for example, 10 nm, 30 nm, or 50 nm), and a width L6 of the first power supply line VDD in the second direction is from 10 nm to 60 nm (for example, 10 nm, 30 nm, or 60 nm).

Refer to FIG. 1, FIG. 6, and FIG. 7. In this scenario, the first pull-down transistor PD1 and the second pull-down transistor PD2 are located at the first metal interconnection layer 41 shown in FIG. 1. For example, the first metal interconnection layer 41 may include at least one first dielectric layer 401 and at least one second dielectric layer 402 that are alternately stacked, and the first pull-down transistor PD1 and the second pull-down transistor PD2 may be disposed at a same second dielectric layer 402. In other words, active regions, sources, drains, and gates 43 of the first pull-down transistor PD1 and the second pull-down transistor PD2 may all be disposed at the same second dielectric layer 402. The first metal interconnection layer 41 may further include the second metal layer M2, and the second metal layer M2 includes the second power supply line VSS. The second power supply line VSS may be connected to one electrode (for example, the source or drain shown as S/D in FIG. 1) of the first pull-down transistor PD1 via the second conductive structure 407. Similarly, the second power supply line VSS may be connected to one electrode of the second pull-down transistor PD2 via another second conductive structure 407. The gate 43 of the first pull-down transistor PD1 and the gate 43 of the second pull-down transistor PD2 extend in a same direction at the first metal interconnection layer 41, and the gate 43 of the first pull-down transistor PD1 and the gate 43 of the second pull-down transistor PD2 are disposed in parallel and spaced apart. One end, of the gate 43 of the first pull-down transistor PD1, close to the second pull-down transistor PD2 may be connected to the other electrode of the second pull-down transistor PD2 via a third contact structure 408, and one end, of the gate 43 of the second pull-down transistor PD2, close to the first pull-down transistor PD1 may be connected via a fourth contact structure 409. Through such arrangement, the first pull-down transistor PD1 and the second pull-down transistor PD2 form a roughly center-rotated symmetric structure (as shown in FIG. 5), and a symmetric center of the structure may be a center of a connection line between a midpoint of the gate 43 of the first pull-down transistor PD1 and a midpoint of the gate 43 of the second pull-down transistor PD2.

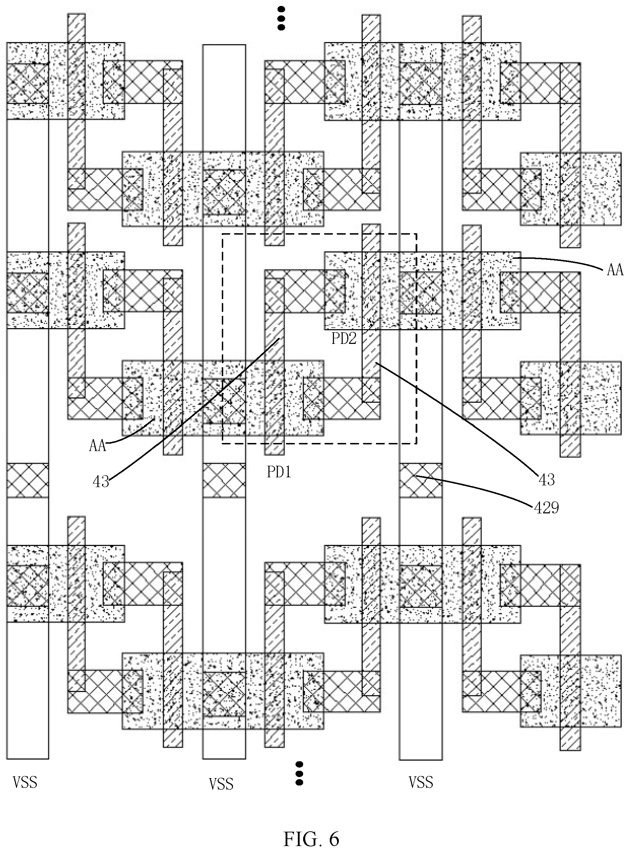

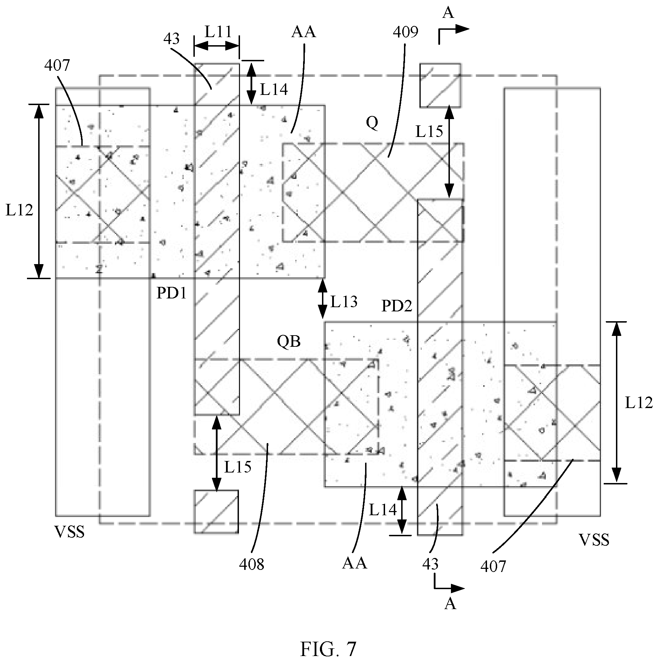

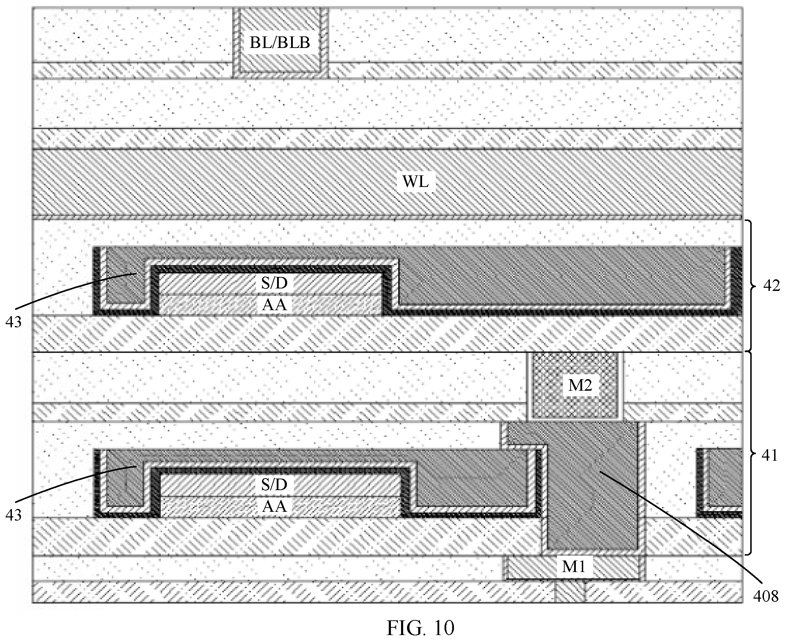

Still refer to FIG. 6, FIG. 7, and FIG. 10. In some embodiments, the gate 43 of the first pull-down transistor PD1 and the gate 43 of the second pull-down transistor PD2 extend in a first direction (a vertical direction in FIG. 7), and widths L11 of the gate 43 of the first pull-down transistor PD1 and the gate 43 of the second pull-down transistor PD2 in a second direction (a horizontal direction in FIG. 7) perpendicular to the first direction are from 5 nm to 100 nm (for example, 5 nm, 50 nm, or 100 nm). An active region AA of the first pull-down transistor PD1 and an active region AA of the second pull-down transistor PD2 extend in the second direction, widths L12 of the active region AA of the first pull-down transistor PD1 and the active region AA of the second pull-down transistor PD2 in the first direction are from 5 nm to 200 nm (for example, 5 nm, 100 nm, or 200 nm), and a distance L13 between the active region AA of the first pull-down transistor PD1 and the active region AA of the second pull-down transistor PD2 in the first direction is from 5 nm to 50 nm (for example, 5 nm, 10 nm, or 50 nm). The gate 43 of the first pull-down transistor PD1 extends in a direction away from the second pull-up transistor PU2, and an exceeding distance L14 to the active region AA of the first pull-down transistor PD1 is from 5 nm to 50 nm (for example, 5 nm, 10 nm, or 50 nm). The gate 43 of the second pull-down transistor PD2 extends in a direction away from the first pull-down transistor PD1, and an exceeding distance L14 to the active region AA of the second pull-down transistor PD2 is from 5 nm to 50 nm (for example, 5 nm, 10 nm, or 50 nm). A distance L15 between gates 43 of first pull-down transistors PD1 in adjacent memory cells is from 5 nm to 80 nm (for example, 5 nm, 40 nm, or 80 nm), and a distance L15 between gates 43 of second pull-down transistors PD2 in the adjacent memory cells is from 5 nm to 80 nm (for example, 5 nm, 40 nm, or 80 nm).

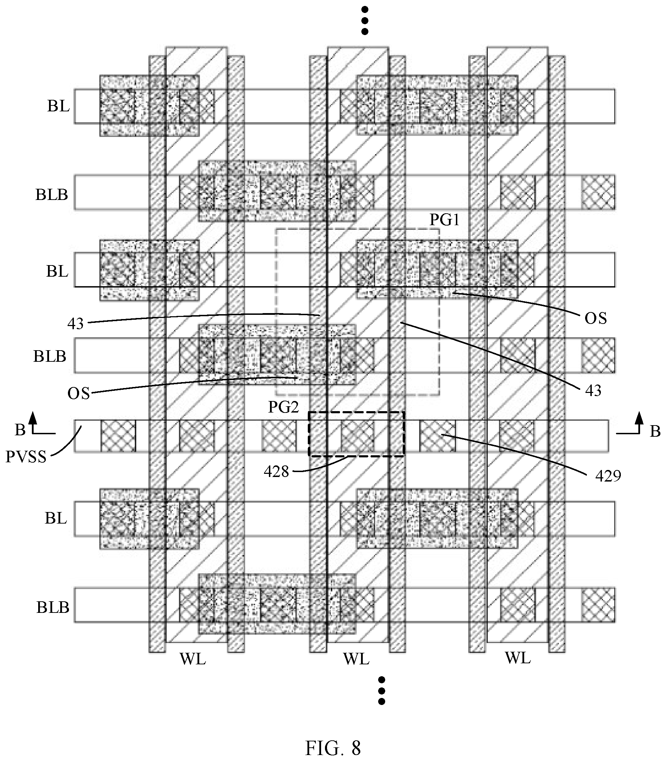

Refer to FIG. 8 to FIG. 10. In some implementations, the first passgate transistor PG1 and the second passgate transistor PG2 are disposed at the second metal interconnection layer 42 shown in FIG. 1, the third metal layer M3 and the fourth metal layer M4 are stacked on a side that is of the second metal interconnection layer 42 and that is away from the substrate 1, and the third metal layer M3 may be located between the fourth metal layer M4 and the second metal interconnection layer 42. The first dielectric layer 401 and/or the second dielectric layer 402 may be stacked between the third metal layer M3 and the fourth metal layer M4, to implement insulation between the third metal layer M3 and the fourth metal layer M4. For example, the third metal layer M3 may include the word line WL, and the fourth metal layer M4 may include the bit line BL and the bit line bar BLB that are spaced apart. The gates 43 of the first passgate transistor PG1 and the second passgate transistor PG2 are connected to the word line WL. For example, gates 43 of a plurality of first passgate transistors PG1 in a plurality of memory cells may be of an integrated structure. Correspondingly, gates 43 of second passgate transistors PG2 in the plurality of memory cells are of an integrated structure, a gate 43 of at least one first passgate transistor PG1 and a gate 43 of at least one second passgate transistor PG2 in the plurality of memory cells are connected via a fifth contact structure 428, and the fifth contact structure 428 is connected to the word line WL. Through such arrangement, the plurality of memory cells may share one fifth contact structure 428, that is, gates 43 of the first passgate transistors PG1 and gates 43 of the second passgate transistors PG2 of the plurality of memory cells are connected to the word line WL via the fifth contact structure 428, thereby simplifying a connection structure. It may be understood that the fifth contact structure 428, the gate 43 of the first passgate transistor PG1, and the gate 43 of the second passgate transistor PG2 may be of an integrated structure, that is, the fifth contact structure 428, the gate 43 of the first passgate transistor PG1, and the gate 43 of the second passgate transistor PG2 may be disposed at a same layer and formed at the same time. Through such arrangement, the fifth contact structure 428 does not need to be additionally disposed, so that manufacturing difficulty and structure complexity can be reduced.

Certainly, in some implementations, the second metal interconnection layer 42 may include the third metal layer M3, and the third metal layer M3 may be disposed away from the first metal interconnection layer 41.

In the foregoing implementation, one electrode of the first passgate transistor PG1 is connected to the fourth contact structure 409 via a sixth contact structure 411, and the fourth contact structure 409 is further connected to the second contact structure 308, so that the sixth contact structure 411, the fourth contact structure 409, and the second contact structure 308 form the first storage node Q. The other electrode of the first passgate transistor PG1 may be connected to the bit line BL via a third conductive structure 410. One electrode of the second passgate transistor PG2 is connected to the third contact structure 408 via a seventh contact structure 412, and the third contact structure 408 is further connected to the first contact structure 307, so that the seventh contact structure 412, the third contact structure 408, and the first contact structure 307 form the second storage node QB. The other electrode of the second passgate transistor PG2 may be connected to the bit line bar BLB via another third conductive structure 410.

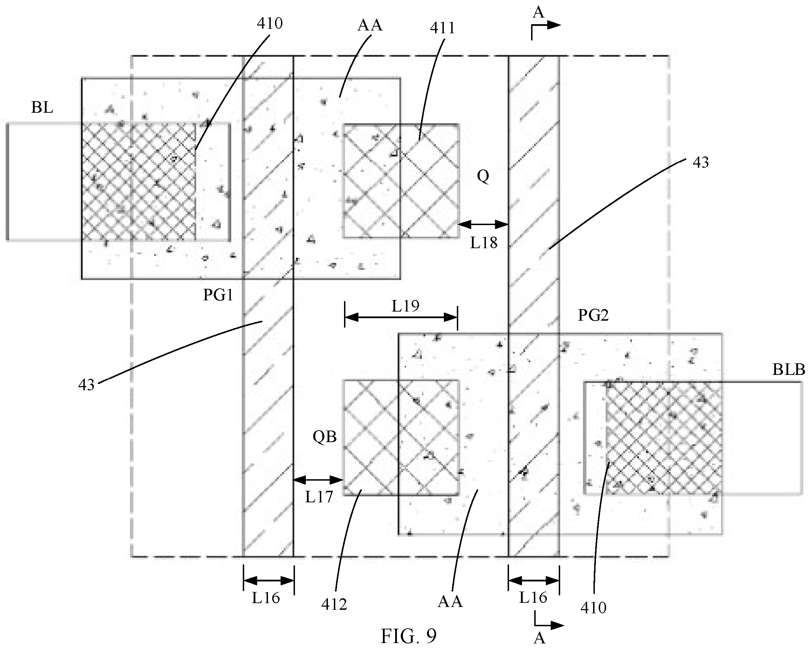

In some embodiments, the gate 43 of the first passgate transistor PG1 and the gate 43 of the second passgate transistor PG2 extend in a first direction (a vertical direction in FIG. 9), and widths L16 of the gate 43 of the first passgate transistor PG1 and the gate 43 of the second passgate transistor PG2 in a second direction (a horizontal direction in FIG. 9) perpendicular to the first direction are from 5 nm to 100 nm (for example, 5 nm, 50 nm, or 100 nm). A distance L17 between the gate 43 of the first passgate transistor PG1 and the seventh contact structure 412 in the second direction is from 5 nm to 50 nm (for example, 5 nm, 30 nm, or 50 nm), and a distance L18 between the gate 43 of the second passgate transistor PG2 and the sixth contact structure 411 in the second direction is from 5 nm to 50 nm (for example, 5 nm, 30 nm, or 50 nm). Widths L19 of the sixth contact structure 411 and the seventh contact structure 412 in the second direction are from 10 nm to 60 nm (for example, 10 nm, 30 nm, or 60 nm).

In some implementations, in each memory cell, the gate 43 of the first passgate transistor PG1 and the gate 43 of the second passgate transistor PG2 extend in a same direction at the second metal interconnection layer 42, so that the gate 43 of the first passgate transistor PG1 and the gate 43 of the second passgate transistor PG2 are disposed in parallel and spaced apart. In this way, the first passgate transistor PG1 and the second passgate transistor PG2 form a roughly centrosymmetric structure (as shown in FIG. 5). A symmetric center may be a center of a connection line between a midpoint of the gate 43 of the first passgate transistor PG1 and a midpoint of the gate 43 of the second passgate transistor PG2.

In this scenario, the plurality of memory cells may be disposed in an array. Correspondingly, a first repetition cell array including the first pull-up transistor PU1 and the second pull-up transistor PU2 at the component layer 30 is disposed, a second repetition cell array including the first pull-down transistor PD1 and the second pull-down transistor PD2 at the first metal interconnection layer 41 is disposed, and a third repetition cell array including the first passgate transistor PG1 and the second passgate transistor PG2 at the second metal interconnection layer 42 is disposed. First pull-up transistors PU1 of each column may be connected to a same first power supply line VDD (sharing the first power supply line VDD), and similarly, second pull-up transistors PU2 of each column may be connected to a same first power supply line VDD. First pull-down transistors PD1 of each column may be connected to a same second power supply line VSS (sharing the second power supply line VSS), and similarly, second pull-down transistors PD2 of each column may be connected to a same second power supply line VSS. Through such arrangement, a quantity of first power supply lines VDD and a quantity of second power supply lines VSS can be reduced, to reduce structure complexity of the chip and facilitate chip manufacturing.

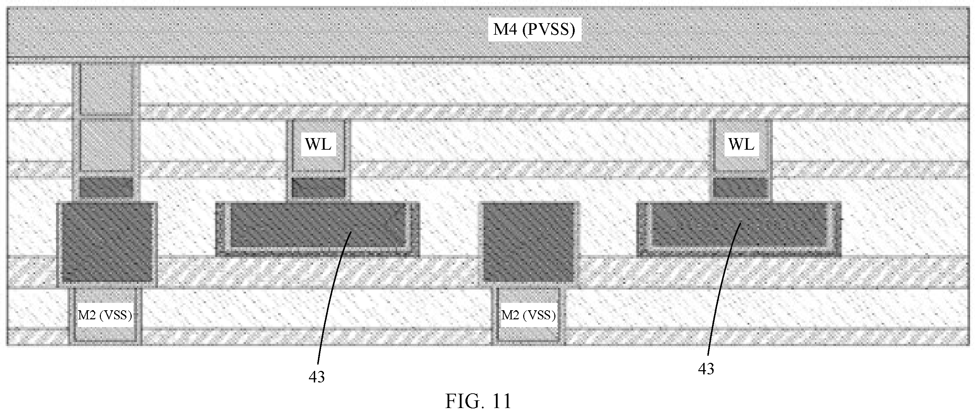

Refer to FIG. 6, FIG. 8, and FIG. 11. In this scenario, when data is read, a current on the second power supply line VSS is large, and the second power supply line VSS has specific resistance. Therefore, as a length of the second power supply line VSS increases, a voltage drop (voltage drop) on the second power supply line VSS is obvious. Correspondingly, the fourth metal layer M4 may further include an auxiliary power supply line PVSS. A second power supply line VSS corresponding to every specific quantity of memory cells may be connected to the auxiliary power supply line PVSS. The voltage drop on the second power supply line VSS can be reduced by disposing the auxiliary power supply line PVSS, thereby improving the performance of the chip. It may be understood that, as shown in FIG. 6 and FIG. 8, the auxiliary power supply line PVSS may be connected to the corresponding second power supply line VSS through a conductive hole 429.

In this scenario, the first pull-up transistor PU1 and the second pull-up transistor PU2 may be silicon field-effect transistors. Correspondingly, the first passgate transistor PG1, the second passgate transistor PG2, the first pull-down transistor PD1, and the second pull-down transistor PD2 may all be oxide semiconductor (Oxide Semiconductor, OS for short) field-effect transistors. In other words, active regions AA of the first passgate transistor PG1, the second passgate transistor PG2, the first pull-down transistor PD1, and the second pull-down transistor PD2 all include oxide semiconductor channels. For example, the first pull-up transistor PU1 and the second pull-up transistor PU2 may be fin field-effect transistors (Fin Field-Effect Transistor, Fin FET for short), to increase a gate control capability of the gate 43. Correspondingly, the first passgate transistor PG1, the second passgate transistor PG2, the first pull-down transistor PD1, and the second pull-down transistor PD2 may be planar channel structures (as shown in FIG. 1). Certainly, the first passgate transistor PG1, the second passgate transistor PG2, the first pull-down transistor PD1, and the second pull-down transistor PD2 may alternatively be fin field-effect transistors or other transistor structures. This is not limited in this embodiment of this application.

In an implementation in which the first passgate transistor PG1, the second passgate transistor PG2, the first pull-down transistor PD1, and the second pull-down transistor PD2 may all be oxide semiconductor field-effect transistors, the gate 43 of the first passgate transistor PG1 may include a gate metal, an electrode layer covered outside the gate metal, and a high dielectric constant (high k) layer covered outside the electrode layer. The high dielectric constant layer is in contact with a channel. For example, a material of the gate metal may include tungsten, a material of the electrode layer may include titanium nitride, tantalum nitride, molybdenum nitride, a TiAl-based alloy, and the like, and a material of the high dielectric constant layer may include hafnium oxide. The gate 43 of the second passgate transistor PG2, the gate 43 of the first pull-down transistor PD1, and the gate 43 of the second pull-down transistor PD2 may have a structure approximately the same as that of the gate 43 of the first passgate transistor PG1. Details are not described herein again. Through such arrangement, the electrode layer can prevent the metal of the gate 43 from diffusing outwards, thereby avoiding performance degradation of the semiconductor oxide field-effect transistor. In addition, the electrode layer may further adjust a work function.

Still refer to FIG. 1. In some embodiments, the metal interconnection layer 40 may include a plurality of stacked first metal interconnection layers 41 and a plurality of stacked second metal interconnection layers 42. The plurality of first metal interconnection layers 41 are located between the second metal interconnection layer 42 and the component layer 30. One first pull-down transistor PD1 and one second pull-down transistor PD2 (as shown in FIG. 7) are disposed at each first metal interconnection layer 41. The first pull-down transistors PD1 at the first metal interconnection layers 41 are connected in parallel, and the second pull-down transistors PD2 at the first metal interconnection layers 41 are connected in parallel. Similarly, one first passgate transistor PG1 and one second passgate transistor PG2 (as shown in FIG. 9) are disposed at each second metal interconnection layer 42. The first passgate transistors PG1 at the second metal interconnection layers 42 are connected in parallel, and the second passgate transistors PG2 at the second metal interconnection layers 42 are connected in parallel. Equivalent currents of the pull-down transistor and the passgate transistor may be increased through a parallel connection, thereby improving the performance of the chip.

Still refer to FIG. 1. It may be understood that the static random access memory may include a core region 10 and a peripheral region 20 located at an edge of the core region 10. The 6T cell array of the static random access memory is disposed in the core region 10, that is, the core region 10 is mainly configured to store data. Each metal layer may further form an auxiliary line. The first power supply line VDD, the second power supply line VSS, the word line WL, the bit line BL, and the bit line bar BLB may be led to the peripheral region 20 via the auxiliary line. The auxiliary line may be connected to the component layer 30 through conductive holes V1, V2, and V3, and a corresponding part of the metal layer. Correspondingly, the auxiliary line may be disposed in the peripheral region 20, to prevent the auxiliary line from occupying space of the core region 10. In addition, because the auxiliary line is disposed in the peripheral region 20, no additional metal layer needs to be added for disposing of the auxiliary line, so that an increase in a quantity of metal layers can be avoided, thereby reducing manufacturing costs.

In some embodiments, the third contact structure 408, the fourth contact structure 409, the conductive hole V1 that is in the peripheral region 20 and that connects the second metal layer M2 to the first metal layer M1 may be manufactured at the same time in a same process and based on a same material, thereby reducing complexity of a chip manufacturing process. Similarly, the sixth contact structure 411, the seventh contact structure 412, the conductive hole V2 that is in the peripheral region 20 and that connects the second metal layer M2 to the third metal layer M3 may be manufactured at the same time in a same process and based on a same material, thereby further reducing the complexity of the chip manufacturing process.

In this scenario, the conductive hole may form a via at a corresponding film layer, and the via is filled with a conductor, to implement an electrical connection between two sides of the film layer. For example, a material of each metal layer may include metal such as copper and tungsten, and a material of the conductor, each contact structure, and each conductive structure may include copper, tungsten, and the like. In some embodiments, a conductive barrier layer is disposed on a periphery of each metal layer, a periphery of the conductor, a periphery of each contact structure, and a periphery of each conductive structure. A material of the conductive barrier layer may include titanium nitride, tantalum nitride, ruthenium, cobalt, and the like. The conductive barrier layer can prevent an internal conductive material from diffusing outwards.

### Scenario 2

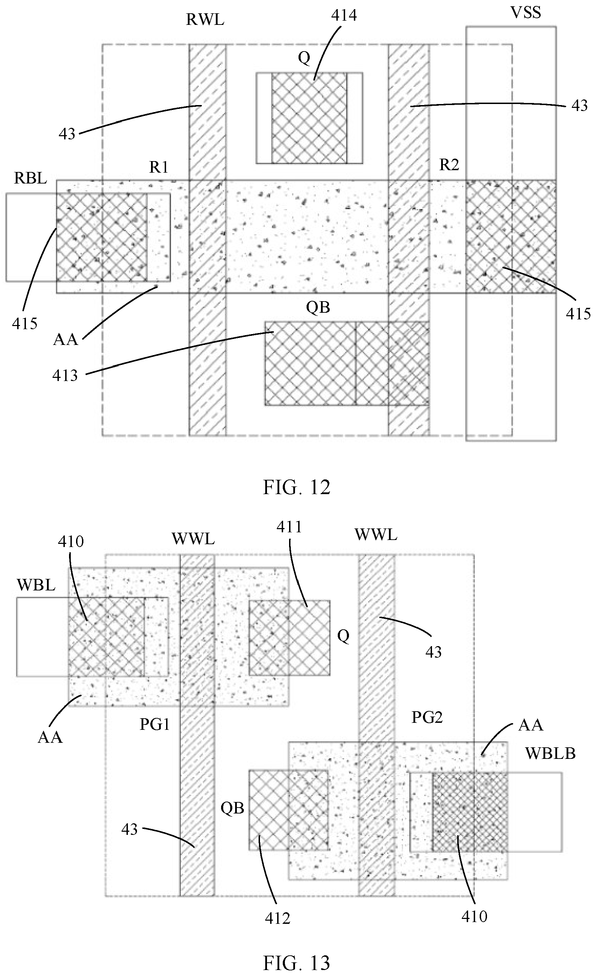

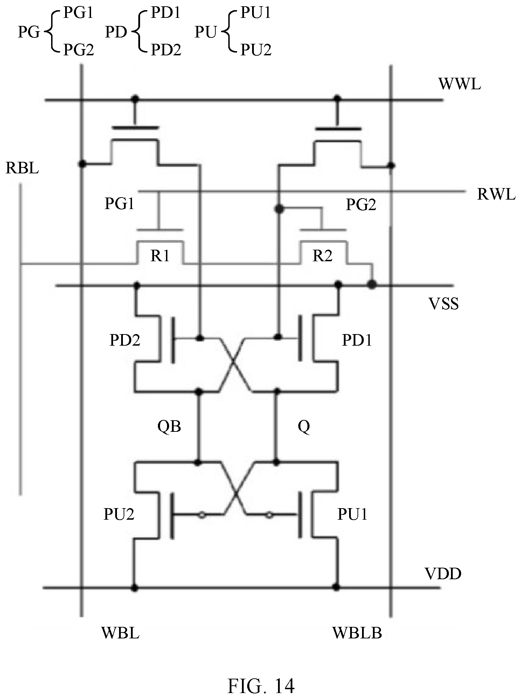

Refer to FIG. 12 to FIG. 14. A difference between this scenario and the scenario 1 lies in that each memory cell includes 8 transistors (8T SRAM). For example, the memory cell may include the first pull-up transistor PU1, the second pull-up transistor PU2, the first pull-down transistor PD1, the second pull-down transistor PD2, the first passgate transistor PG1, the second passgate transistor PG2, a first read transistor R1, and a second read transistor R2. Correspondingly, the metal interconnection layer 40 may include the first metal interconnection layer 41, the second metal interconnection layer 42, and a third metal interconnection layer that are stacked. The second metal interconnection layer 42 may be located between the first metal interconnection layer 41 and the third metal interconnection layer, and the first metal interconnection layer 41 may be disposed close to the component layer 30. The first pull-up transistor PU1 and the second pull-up transistor PU2 may be disposed at the component layer 30, and structures and connection manners of the first pull-up transistor PU1 and the second pull-up transistor PU2 may be the same as those in the scenario 1 (as shown in FIG. 4). The first pull-down transistor PD1 and the second pull-down transistor PD2 are disposed at the first metal interconnection layer 41, and structures and connection manners of the first pull-down transistor PD1 and the second pull-down transistor PD2 may be the same as those in the scenario 1 (as shown in FIG. 7). As shown in FIG. 12, the first read transistor R1 and the second read transistor R2 may be disposed at the second metal interconnection layer 42. A gate 43 of the first read transistor R1 is connected to a first word line RWL, one electrode of the first read transistor R1 is connected to one electrode of the second read transistor R2, and the other electrode of the first read transistor R1 may be connected to a first bit line RBL via a fourth conductive structure 415. A gate 43 of the second read transistor R2 may be connected to a third contact structure 408 via an eighth contact structure 413, and the other electrode of the second read transistor R2 is connected to the second power supply line VSS via another fourth conductive structure 415. The first passgate transistor PG1 and the second passgate transistor PG2 may be disposed at the third metal interconnection layer, structures of the first passgate transistor PG1 and the second passgate transistor PG2 may be approximately the same as those in the scenario 1, a gate 43 of the first passgate transistor PG1 and a gate 43 of the second passgate transistor PG2 may be connected to a second word line WWL, one electrode of the first passgate transistor PG1 is connected to a ninth contact structure 414 at the second metal interconnection layer 42 via a sixth contact structure 411, the ninth contact structure 414 is connected to the fourth contact structure 409, and the other electrode of the first passgate transistor PG1 is connected to a third bit line WBL via a third conductive structure 410. One electrode of the second passgate transistor PG2 is connected to the eighth contact structure 413 via a seventh contact structure 412, and the other electrode of the second passgate transistor PG2 is connected to a second bit line WBLB via another third conductive structure 410.

In the foregoing implementation, the first metal layer M1 may be disposed at the component layer 30, and the first power supply line VDD may be located at the first metal layer M1. A second metal layer M2 may be disposed at the first metal interconnection layer 41, and the second power supply line VSS may be disposed at the second metal layer M2. A third metal layer M3, a fourth metal layer M4, and a fifth metal layer may be disposed at the second metal interconnection layer 42. The first word line RWL and the first bit line RBL may be disposed at any one or more of the third metal layer M3, the fourth metal layer M4, and the fifth metal layer. A sixth metal layer and a seventh metal layer may be disposed at the third metal interconnection layer. The second bit line WBLB, the second word line WWL, and the third bit line WBL may be disposed at the sixth metal layer and/or the seventh metal layer.

It may be understood that the first power supply line VDD, the second power supply line VSS, the first word line RWL, the first bit line RBL, the second bit line WBLB, the second word line WWL, and the third bit line WBL may alternatively be separately routed through another metal layer of the chip. This is not limited in this scenario.

### Scenario 3

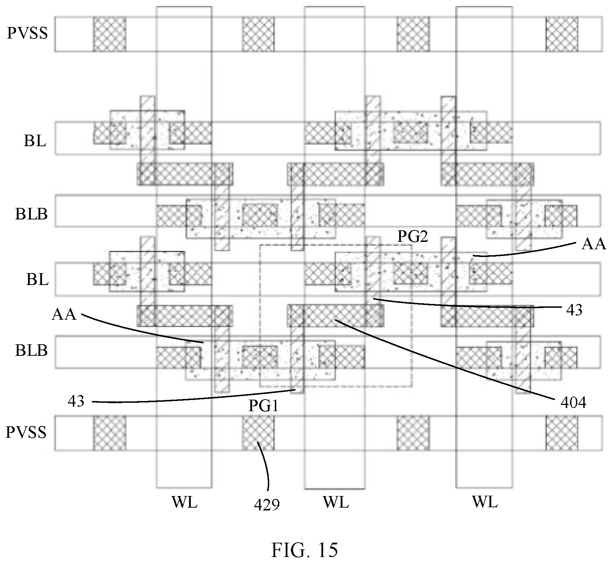

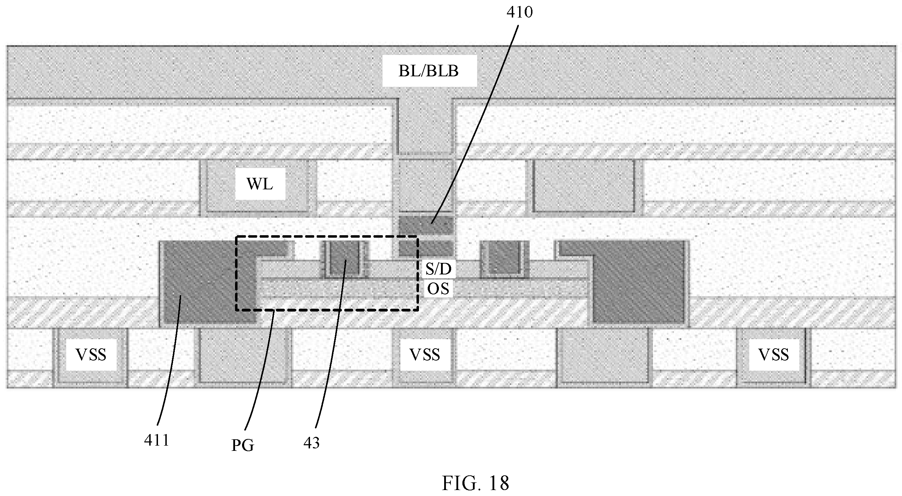

Refer to FIG. 15 to FIG. 18. A difference between this scenario and the scenario 1 lies in that a connection structure of a gate 43 of the first passgate transistor PG1 and a gate 43 of the second passgate transistor PG2 is different. In this scenario, the gate 43 of the first passgate transistor PG1 and the gate 43 of the second passgate transistor PG2 are disposed in parallel and spaced apart at the second metal interconnection layer 42 (as shown in FIG. 1), and a first connection portion 404 is further disposed at the second metal interconnection layer 42. One end that is of the gate 43 of the first passgate transistor PG1 and that is close to the second passgate transistor PG2 is connected, via the first connection portion 404, to one end that is of the gate 43 of the second passgate transistor PG2 and that is close to the first passgate transistor PG1. The first connection portion 404 may be disposed between the first passgate transistor PG1 and the second passgate transistor PG2, and the first connection portion 404 is connected to the word line WL. Through such arrangement, a gate 43 of a first passgate transistor PG1 and a gate 43 of a second passgate transistor PG2 in each memory cell are connected to the word line WL via the corresponding first connection portion 404. In comparison with the gates 43 of the first passgate transistors PG1 and the gates 43 of the second passgate transistors PG2 in the plurality of memory cells that are connected to the word line WL via the same fifth contact structure, parasitic resistance of the word line WL can be reduced, and a signal transmission response speed of the word line WL can be improved.

It may be understood that the first connection portion 404 may be disposed on a side that is of the gate 43 of the first passgate transistor PG1 and that is away from the component layer and a side that is of the gate 43 of the second passgate transistor PG2 and that is away from the component layer, and the first connection portion 404 is located on a side that is of the third metal layer M3 and that is close to the component layer, so that the gates 43 corresponding to the first connection portion 404 are connected to the word line WL.

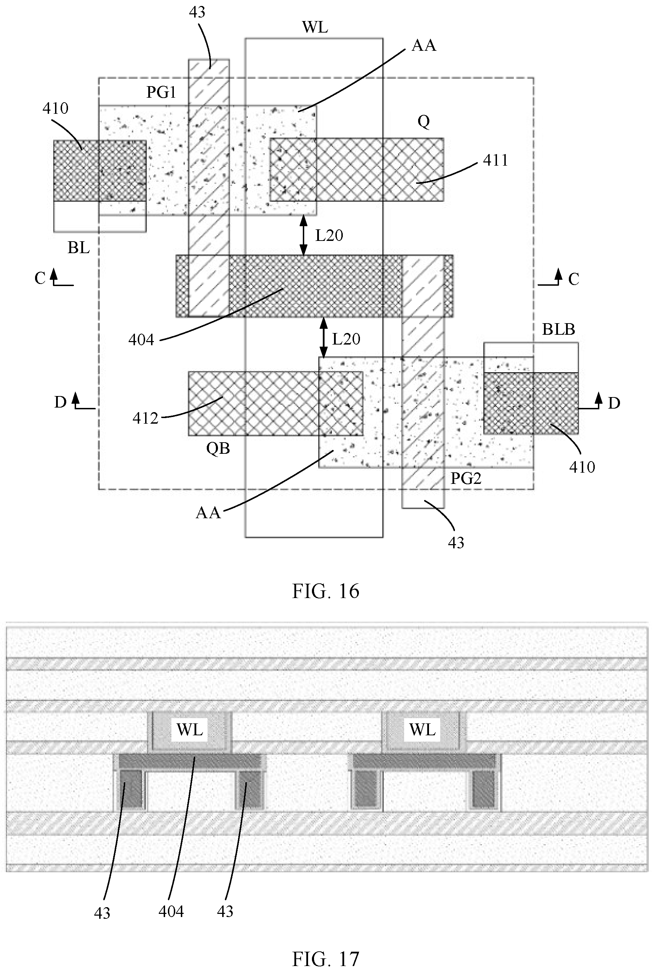

Refer to FIG. 16 and FIG. 17. In this scenario, the first connection portion 404 is located between the first passgate transistor PG1 and the second passgate transistor PG2. Through such arrangement, the gate 43 of the first passgate transistor PG1 extends only to the second passgate transistor PG2 to the first connection portion 404, to reduce an extension length of the gate 43 of the first passgate transistor PG1, and further enable a seventh contact structure 412 to extend to the gate 43 of the first passgate transistor PG1 in a direction perpendicular to the gate 43 of the first passgate transistor PG1. This increases a size of the seventh contact structure 412, and facilitates a connection between the seventh contact structure 412 and a third contact structure 408. In addition, a contact area between the seventh contact structure 412 and the third contact structure 408 may be increased, thereby reducing connection resistance between the seventh contact structure 412 and the third contact structure 408. Similarly, the gate 43 of the second passgate transistor PG2 extends only to the first passgate transistor PG1 to the first connection portion 404, to reduce an extension length of the gate 43 of the second passgate transistor PG2, and further enable a sixth contact structure 411 to extend to the gate 43 of the second passgate transistor PG2 in a direction perpendicular to the gate 43 of the first passgate transistor PG1. This increases a size of the sixth contact structure 411, and facilitates a connection between the sixth contact structure 411 and a fourth contact structure 409. In addition, a contact area between the sixth contact structure 411 and the fourth contact structure 409 may be increased, thereby reducing connection resistance between the sixth contact structure 411 and the fourth contact structure 409.

For example, the gate 43 of the first passgate transistor PG1 and the gate 43 of the second passgate transistor PG2 extend in a first direction (a vertical direction in FIG. 16). A distance L20 between an active region AA of the first passgate transistor PG1 and the first connection portion 404 in the first direction is from 5 nm to 50 nm (for example, 5 nm, 30 nm, or 50 nm), and a distance L20 between an active region of the second passgate transistor PG2 and the first connection portion in the first direction is from 5 nm to 50 nm (for example, 5 nm, 30 nm, or 50 nm).

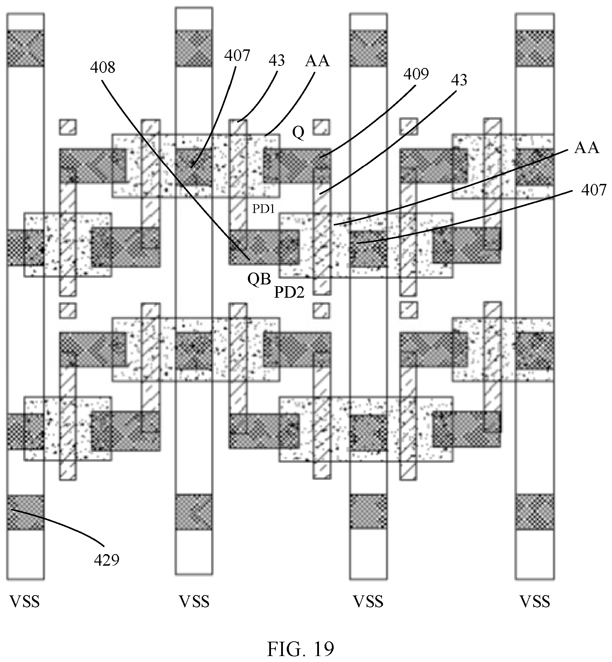

As shown in FIG. 15 and FIG. 19, in this scenario, a fourth metal layer M4 may further include an auxiliary power supply line PVSS. A second power supply line VSS corresponding to every specific quantity of memory cells may be connected to the auxiliary power supply line PVSS. A voltage drop on the second power supply line VSS can be reduced by disposing the auxiliary power supply line PVSS, thereby improving the performance of the chip. It may be understood that the auxiliary power supply line PVSS may be connected to the corresponding second power supply line VSS through a conductive hole 429.

### Scenario 4

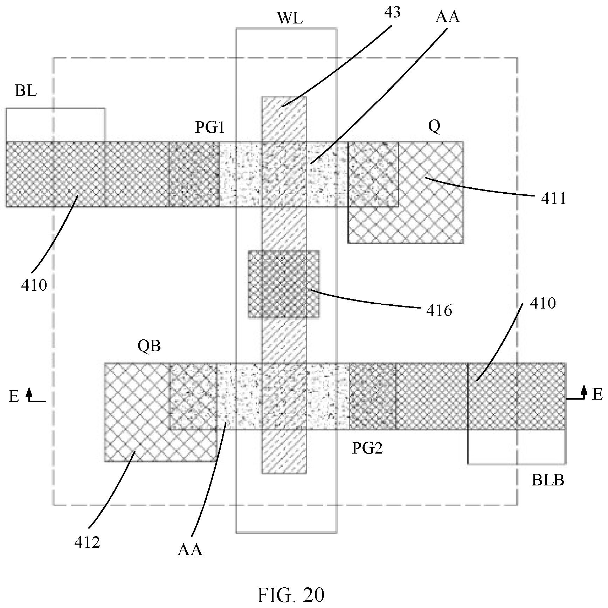

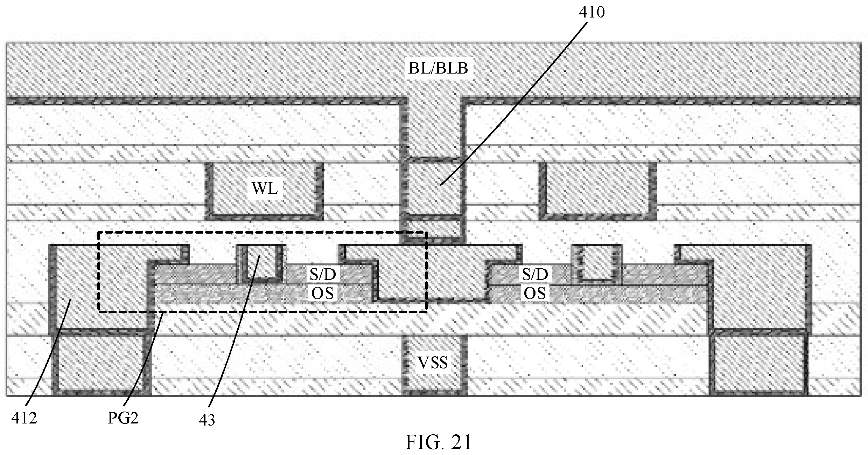

Refer to FIG. 20 and FIG. 21. A difference between this scenario and the scenario 1 lies in that, in a same memory cell, a gate 43 of the first passgate transistor PG1 and a gate 43 of the second passgate transistor PG2 are of an integrated structure, that is, the gate 43 of the first passgate transistor PG1 and the gate 43 of the second passgate transistor PG2 are short-circuited in extension directions of the gate 43 of the first passgate transistor PG1 and the gate 43 of the second passgate transistor PG2. A second connection portion 416 is further disposed at the second metal interconnection layer 42, the second connection portion 416 is located between the first passgate transistor PG1 and the second passgate transistor PG2, the second connection portion 416 is connected to the gate 43 of the first passgate transistor PG1, and the second connection portion 416 is connected to the word line WL. Through such arrangement, the gate 43 of the first passgate transistor PG1 and the gate 43 of the second passgate transistor PG2 are of the integrated structure. This can simplify a structure of the static random access memory and facilitate manufacturing of the chip. In addition, a gate 43 of a first passgate transistor PG1 and a gate 43 of a second passgate transistor PG2 in each memory cell are connected to the word line WL via one second connection portion 416, which can reduce parasitic resistance.

In the foregoing implementation, the gate 43 of the first passgate transistor PG1 and the gate 43 of the second passgate transistor PG2 along a same straight line. Through such arrangement, widths of the first passgate transistor PG1 and the second passgate transistor PG2 in a direction perpendicular to the straight line can be reduced, and sizes occupied by the first passgate transistor PG1 and the second passgate transistor PG2 in the direction perpendicular to the straight line can be reduced, thereby improving structural compactness of the chip. In addition, a seventh contact structure 412 may be enabled to extend away from the gate 43 of the second passgate transistor PG2 in a direction perpendicular to the gate 43 of the second passgate transistor PG2. This increases a size of the seventh contact structure 412, and facilitates a connection between the seventh contact structure 412 and a third contact structure 408 (as shown in FIG. 7). In addition, a contact area between the seventh contact structure 412 and the third contact structure 408 may be increased, thereby reducing connection resistance between the seventh contact structure 412 and the third contact structure 408. Similarly, a sixth contact structure 411 may be enabled to extend away from the first passgate transistor PG1 in a direction perpendicular to the gate 43 of the first passgate transistor PG1. This increases a size of the sixth contact structure 411, and facilitates a connection between the sixth contact structure 411 and a fourth contact structure 409 (as shown in FIG. 7). In addition, a contact area between the sixth contact structure 411 and the fourth contact structure 409 may be increased, thereby reducing connection resistance between the sixth contact structure 411 and the fourth contact structure 409.

In this scenario, projection of the word line WL on the second metal interconnection layer 42 may cover the gate 43 of the first passgate transistor PG1 and the gate 43 of the second passgate transistor PG2 that correspond to the word line WL. Correspondingly, the second connection portion 416 may be located between the first passgate transistor PG1 and the second passgate transistor PG2, and is approximately located at a middle location between the first passgate transistor PG1 and the second passgate transistor PG2, to enable current paths between the first passgate transistor PG1 and the word line WL to be the same as those between the second passgate transistor PG2 and the word line WL. This ensures that voltages of the gates 43 of the first passgate transistor PG1 and the second passgate transistor PG2 are approximately equal.

### Scenario 5

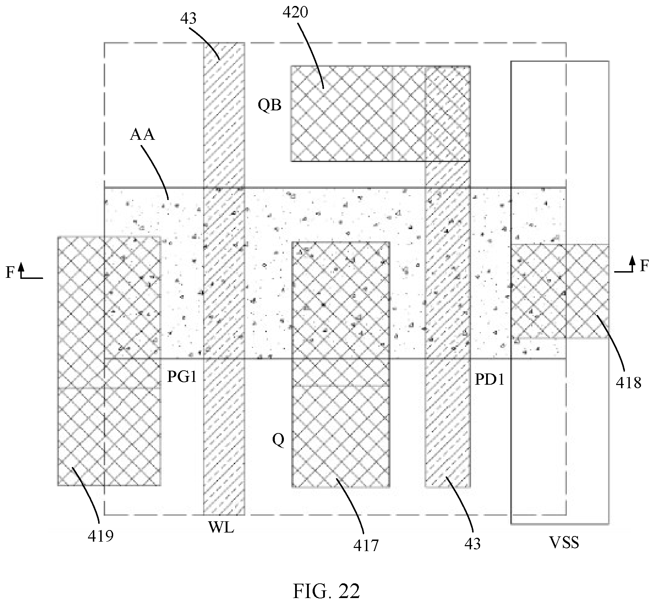

Refer to FIG. 22 to FIG. 24. A difference between this scenario and the scenario 1 lies in that the first passgate transistor PG1 and the first pull-down transistor PD1 are located at the first metal interconnection layer 41, and correspondingly, the second passgate transistor PG2 and the second pull-down transistor PD2 are located at the second metal interconnection layer 42. Alternatively, the first passgate transistor PG1 and the first pull-down transistor PD1 are located at the second metal interconnection layer 42, and correspondingly, the second passgate transistor PG2 and the second pull-down transistor PD2 are located at the first metal interconnection layer 41.

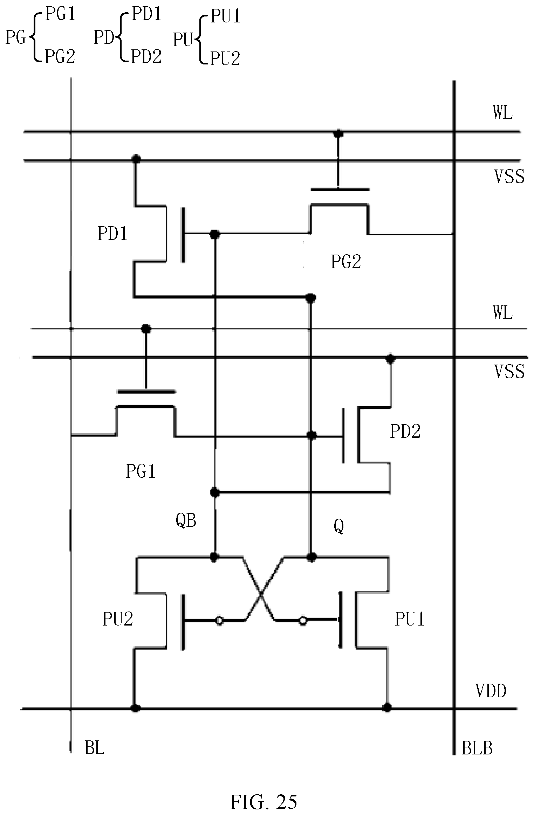

In an implementation in which the first passgate transistor PG1 and the first pull-down transistor PD1 are located at the first metal interconnection layer 41, and the second passgate transistor PG2 and the second pull-down transistor PD2 are located at the second metal interconnection layer 42, one electrode of the first pull-up transistor PU1 and one electrode of the second pull-up transistor PU2 are connected to the first power supply line VDD (as shown in FIG. 25), the other electrode of the first pull-up transistor PU1 is connected to a gate 43 of the second pull-up transistor PU2, and the other electrode of the second pull-up transistor PU2 is connected to a gate 43 of the first pull-up transistor PU1. The gate 43 of the first pull-up transistor PU1 is further connected to one electrode of the second pull-down transistor PD2, the other electrode of the second pull-down transistor PD2 is connected to one second power supply line VSS, a gate 43 of the second pull-down transistor PD2 is connected to the gate 43 of the second pull-up transistor PU2, one electrode of the first pull-down transistor PD1 is connected to the gate 43 of the second pull-up transistor PU2, the other electrode of the first pull-down transistor PD1 is connected to another second power supply line VSS, a gate 43 of the first pull-down transistor PD1 is connected to the gate 43 of the first pull-up transistor PU1, one electrode of the first passgate transistor PG1 is connected to the gate 43 of the second pull-down transistor PD2, the other electrode of the first passgate transistor PG1 is connected to the bit line BL, a gate 43 of the first passgate transistor PG1 is connected to one word line WL, one electrode of the second passgate transistor PG2 is connected to the gate 43 of the first pull-down transistor PD1, the other electrode of the second passgate transistor PG2 is connected to the bit line bar BLB, and a gate 43 of the second passgate transistor PG2 is connected to another word line WL. The total of 6 transistors: the first passgate transistor PG1, the second passgate transistor PG2, the first pull-up transistor PU1, the second pull-up transistor PU2, the first pull-down transistor PD1, and the second pull-down transistor PD2, form the memory cell for data storage.

In the foregoing implementation, the electrode of the first passgate transistor PG1, the electrode of the first pull-down transistor PD1, the gate 43 of the second pull-down transistor PD2, and the gate 43 of the second pull-up transistor PU2 are connected to form the first storage node Q. The electrode of the second passgate transistor PG2, the electrode of the second pull-down transistor PD2, the gate 43 of the first pull-down transistor PD1, and the gate 43 of the first pull-up transistor PU1 are connected to form the second storage node QB.

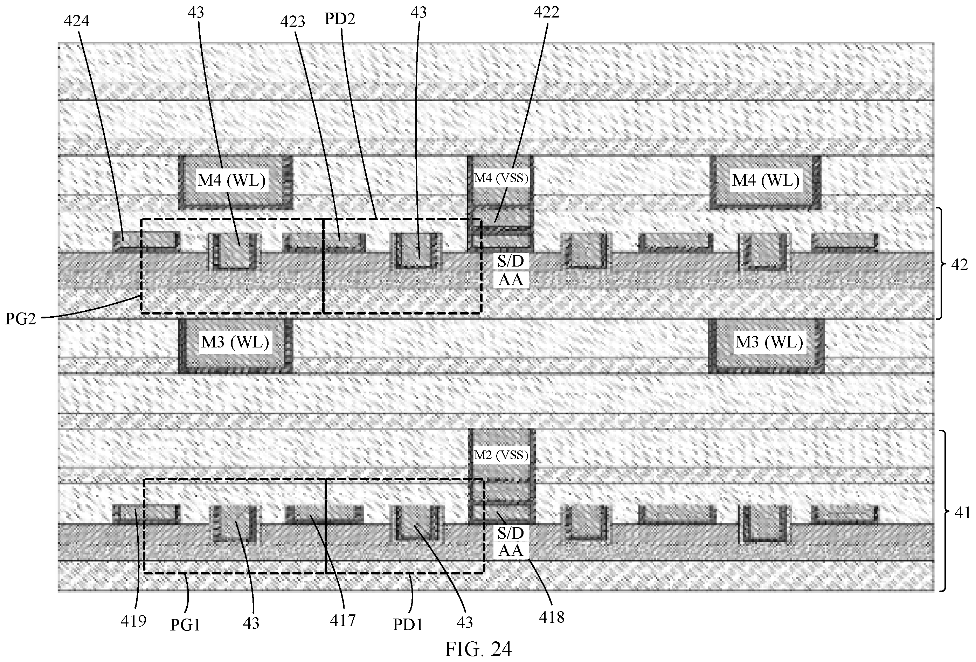

As shown in FIG. 22 and FIG. 24, the first passgate transistor PG1 and the first pull-down transistor PD1 are located at the first metal interconnection layer 41, and the electrode of the first passgate transistor PG1 is connected to the electrode of the first pull-down transistor PD1. Correspondingly, an electrode of the first passgate transistor PG1 and an electrode of the first pull-down transistor PD1 that are close to each other may be disposed as an integrated structure. Through such arrangement, there is no need to additionally dispose another structure used to connect one electrode of the first passgate transistor PG1 and one electrode of the first pull-down transistor PD1, thereby simplifying the structure of the chip. In addition, the electrode of the first passgate transistor PG1 and the electrode of the first pull-down transistor PD1 are of the integrated structure, and the electrode of the first passgate transistor PG1 and the electrode of the first pull-down transistor PD1 may be formed at the same time by using a same process, thereby facilitating manufacturing of the chip. It may be understood that the electrode of the first passgate transistor PG1 and the electrode of the first pull-down transistor PD1 may be connected to a second contact structure 308 shown in FIG. 4 via a tenth contact structure 417, the other electrode of the first passgate transistor PG1 is connected to the bit line via a sixth conductive structure 419, the other electrode of the first pull-down transistor PD1 is connected to the second power supply line VSS via a fifth conductive structure 418, the gate 43 of the first pull-down transistor PD1 is connected to a first contact structure 307 shown in FIG. 4 via an eleventh contact structure 420, and the gate 43 of the first passgate transistor PG1 is connected to the word line WL. For example, the second power supply line VSS is located at a second metal layer M2, to reduce distances between the second power supply line VSS and the first passgate transistor PG1 and between the second power supply line VSS and the first pull-down transistor PD1, to facilitate the connection.

In some embodiments, an active region AA of the first passgate transistor PG1 and an active region AA of the first pull-down transistor PD1 may also be of an integrated structure, that is, the active region AA of the first passgate transistor PG1 and an active region AA of the second passgate transistor PG2 may be formed at the same time by using a same process, thereby further facilitating manufacturing of the chip.

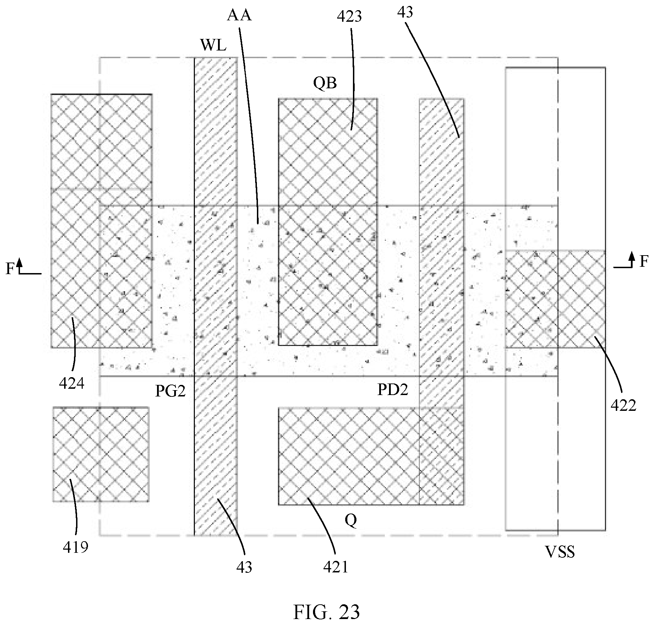

Refer to FIG. 23 and FIG. 24. Similarly, the second passgate transistor PG2 and the second pull-down transistor PD2 are located at the second metal interconnection layer 42, and the electrode of the second passgate transistor PG2 is connected to the electrode of the second pull-down transistor PD2. Correspondingly, an electrode of the second passgate transistor PG2 and an electrode of the second pull-down transistor PD2 that are close to each other may be disposed as an integrated structure. Through such arrangement, there is no need to additionally dispose another structure used to connect one electrode of the second passgate transistor PG2 and one electrode of the second pull-down transistor PD2, thereby simplifying the structure of the chip. In addition, the electrode of the second passgate transistor PG2 and the electrode of the second pull-down transistor PD2 are of the integrated structure, and the electrode of the second passgate transistor PG2 and the electrode of the second pull-down transistor PD2 may be formed at the same time by using a same process, thereby facilitating manufacturing of the chip. It may be understood that the electrode of the second passgate transistor PG2 and the electrode of the second pull-down transistor PD2 are connected to the eleventh contact structure 420 via a thirteenth contact structure 423, the gate 43 of the second passgate transistor PG2 is connected to the word line, and the other electrode of the second passgate transistor PG2 may be connected to the bit line bar BLB via an eighth conductive structure 424. The gate 43 of the second pull-down transistor PD2 may be connected to the tenth contact structure 417 via a twelfth contact structure 421, and the other electrode of the second pull-down transistor PD2 may be connected to the second power supply line VSS via a seventh conductive structure 422. For example, the second power supply line VSS is located at a fourth metal layer M4, to reduce distances between the second power supply line VSS and the second passgate transistor PG2 and between the second power supply line VSS and the second pull-down transistor PD2, to facilitate the connection.

In some embodiments, an active region AA of the second passgate transistor PG2 and an active region AA of the second pull-down transistor PD2 may also be of an integrated structure, that is, the active region AA of the second passgate transistor PG2 and the active region AA of the second pull-down transistor PD2 may be formed at the same time by using a same process, thereby further facilitating manufacturing of the chip.

In this scenario, the gate 43 of the first passgate transistor PG1 is connected to the word line WL. For example, the word line WL may be located at the third metal layer M3. Through such arrangement, a distance between the word line WL and the gate 43 of the first passgate transistor PG1 can be reduced, to facilitate the connection. The gate 43 of the second passgate transistor PG2 is connected to the another word line WL. The word line WL may be located at the fourth metal layer M4, to reduce a distance between the word line WL and the gate 43 of the second passgate transistor PG2, to facilitate the connection.

An embodiment of this application further provides a chip manufacturing method, including:
S101: Manufacture, by using a front-end-of-line process on a substrate, a component layer and a pull-up transistor located at the component layer, where the component layer includes a logic circuit.

As shown in FIG. 1, for example, the pull-up transistor PU and the logic circuit may be manufactured on the substrate 1 by using the front-end-of-line process, and the third dielectric layer 305 is formed on the substrate 1. The third dielectric layer 305 covers the substrate 1 and is located on the logic circuit and the pull-up transistor PU that are on the substrate 1.

In some embodiments, after the third dielectric layer 305 is formed, the fourth dielectric layer 306 may be formed on the third dielectric layer 305, and the first metal layer M1 may be formed on the fourth dielectric layer 306. For example, the first metal layer M1 and the first power supply line VDD may be formed by using a process such as patterning, etching, or deposition.

In the foregoing implementation, before the first metal layer M1 is formed, a first hole may be formed on the third dielectric layer 305 through etching, and a second hole may be formed on the fourth dielectric layer 306. The first hole is in contact with one electrode of the pull-up transistor PU, and the second hole is in communication with the first hole. Then, the first conductive portion 303 is formed in the first hole, and the second conductive portion 304 is formed in the second hole. The first conductive portion 303 is in contact with one electrode of the pull-up transistor PU, and the first conductive portion 303 is further in contact with the second conductive portion 304. After the first power supply line VDD is formed, the first power supply line VDD covers at least a part of the second conductive portion 304, so that the first power supply line VDD is connected to one electrode of the pull-up transistor PU via the first conductive portion 303 and the second conductive portion 304.

In this embodiment of this application, after the component layer 30 is formed, the method further includes:

S102: Form, by using a back-end-of-line process in a stacked manner on the component layer, a metal interconnection layer, and a passgate transistor and a pull-down transistor that are located at the metal interconnection layer.

It may be understood that the metal interconnection layer 40, and the passgate transistor and the pull-down transistor PD that are located at the metal interconnection layer 40 are formed by using the back-end-of-line process. Correspondingly, in a static random access memory including the passgate transistor, the pull-up transistor PU, and the pull-down transistor PD, the pull-up transistor PU is located at the component layer 30, and the passgate transistor and the pull-down transistor PD are located at the metal interconnection layer 40, so that the static random access memory is located inside a chip.

In some embodiments, the pull-up transistor PU is a P-type transistor, and the passgate transistor and the pull-down transistor PD are N-type transistors. An oxide semiconductor transistor manufactured by using the back-end-of-line process is more easily manufactured as an N-type transistor, and the passgate transistor PG and the pull-down transistor PD that are manufactured by using the back-end-of-line process are the N-type transistors. This can facilitate manufacturing of the passgate transistor PG and the pull-down transistor PD.

In some embodiments, a material of the substrate 1 may include silicon, that is, the substrate 1 is a silicon substrate, and correspondingly, the pull-up transistor PU may be a silicon field-effect transistor, that is, a material of an active region of the pull-up transistor PU may include monocrystalline silicon. Through such arrangement, this further facilitates manufacturing of the pull-up transistor PU.

In the foregoing implementation, forming, by using the back-end-of-line process in the stacked manner on the component layer 30, the metal interconnection layer 40, and the passgate transistor PG and the pull-down transistor PD that are located at the metal interconnection layer 40 includes:
forming the first metal interconnection layer 41 and the second metal interconnection layer 42 by using the back-end-of-line process in the stacked manner on the component layer 30. The first metal interconnection layer 41 is located between the second metal interconnection layer 42 and the component layer 30, and the passgate transistor PG and the pull-down transistor PD are disposed at the first metal interconnection layer 41 and the second metal interconnection layer 42. Through such arrangement, in comparison with that the passgate transistor PG and the pull-down transistor PD are disposed at the first metal interconnection layer 41 or the second metal interconnection layer 42, areas of the static random access memory and the chip can be reduced.

In an implementation in which a memory cell of the static random access memory includes 6 transistors, correspondingly, the passgate transistor PG includes the first passgate transistor PG1 and the second passgate transistor PG2, the pull-up transistor PU includes the first pull-up transistor PU1 and the second pull-up transistor PU2, and the pull-down transistor PD includes the first pull-down transistor PD1 and the second pull-down transistor PD2.

In some embodiments, forming the first metal interconnection layer 41 and the second metal interconnection layer 42 by using the back-end-of-line process in the stacked manner on the component layer 30 includes: forming, by using the back-end-of-line process in the stacked manner on the component layer 30, the first metal interconnection layer 41, and the first pull-down transistor PD1 and the second pull-down transistor PD2 that are located at the first metal interconnection layer 41. Then, the second metal interconnection layer 42, and the first passgate transistor PG1 and the second passgate transistor PG2 that are located at the second metal interconnection layer 42 are formed by using the back-end-of-line process in the stacked manner on the first metal interconnection layer 41. In other words, the first passgate transistor PG1 and the second passgate transistor PG2 are disposed at the second metal interconnection layer 42, and the first pull-down transistor PD1 and the second pull-down transistor PD2 are disposed at the first metal interconnection layer 41. Through such arrangement, it can be ensured that there are no excessive transistors at the first metal interconnection layer 41 and the second metal interconnection layer 42, thereby avoiding excessively complex structures of the first metal interconnection layer 41 and the second metal interconnection layer 42.

In another embodiment, forming the first metal interconnection layer 41 and the second metal interconnection layer 42 by using the back-end-of-line process in the stacked manner on the component layer 30 includes: forming, by using the back-end-of-line process in the stacked manner on the component layer 30, the first metal interconnection layer 41, and the first pull-down transistor PD1 and the first passgate transistor PG1 that are located at the first metal interconnection layer 41. Then, the second metal interconnection layer 42, and the second pull-down transistor PD2 and the second passgate transistor PG2 that are located at the second metal interconnection layer 42 are formed by using the back-end-of-line process in the stacked manner on the first metal interconnection layer 41. Through such arrangement, it can be ensured that there are no excessive transistors at the first metal interconnection layer 41 and the second metal interconnection layer 42, thereby avoiding excessively complex structures of the first metal interconnection layer 41 and the second metal interconnection layer 42.

In the chip manufactured according to the chip manufacturing method provided in this embodiment of this application, the component layer 30 includes the logic circuit, and the component layer 30 is manufactured by using the front-end-of-line process. The metal interconnection layer 40 is stacked on a side that is of the component layer 30 and that is away from the substrate 1, and the metal interconnection layer 40 is manufactured by using the back-end-of-line process. The static random access memory includes the passgate transistor PG, the pull-up transistor PU, and the pull-down transistor PD, the pull-up transistor PU is disposed at the component layer 30, and the passgate transistor PG and the pull-down transistor PD are disposed at the metal interconnection layer 40. Through such arrangement, in comparison with a case in which the pull-up transistor PU, the passgate transistor PG, and the pull-down transistor PD are all manufactured by using the front-end-of-line process, a quantity of components manufactured by using the front-end-of-line process can be reduced, an area of the component layer is reduced, and the area of the chip is further reduced.

In the descriptions of this specification, the described specific features, structures, materials, or characteristics may be combined in a proper manner in any one or more of embodiments or examples.

Finally, it should be noted that the foregoing embodiments are merely intended for describing the technical solutions of this application other than limiting this application. Although this application is described in detail with reference to the foregoing embodiments, persons of ordinary skill in the art should understand that they may still make modifications to the technical solutions described in the foregoing embodiments or make equivalent replacements to some technical features thereof, without departing from the scope of the technical solutions of embodiments of this application.

## Claims

1. A chip, comprising:
a substrate;
a component layer, wherein the component layer is disposed on the substrate, the component layer comprises a logic circuit, and the component layer is configured to be manufactured by using a front-end-of-line process;
a metal interconnection layer, wherein the metal interconnection layer is stacked on a side that is of the component layer and that is away from the substrate, and the metal interconnection layer is configured to be manufactured by using a back-end-of-line process; and
a static random access memory, wherein the static random access memory comprises a passgate transistor, a pull-up transistor, and a pull-down transistor, the pull-up transistor is disposed at the component layer, and the passgate transistor and the pull-down transistor are disposed at the metal interconnection layer.

2. The chip according to claim 1, wherein the metal interconnection layer comprises a first metal interconnection layer and a second metal interconnection layer that are stacked, the first metal interconnection layer is located between the second metal interconnection layer and the component layer, and the passgate transistor and the pull-down transistor are disposed at the first metal interconnection layer and the second metal interconnection layer.

3. The chip according to claim 2, wherein the passgate transistor comprises a first passgate transistor and a second passgate transistor, the pull-up transistor comprises a first pull-up transistor and a second pull-up transistor, and the pull-down transistor comprises a first pull-down transistor and a second pull-down transistor; and the static random access memory comprises a memory cell, the memory cell is configured to store data, the memory cell is a 6T memory cell, and the memory cell comprises: the first passgate transistor, the second passgate transistor, the first pull-up transistor, the second pull-up transistor, the first pull-down transistor, and the second pull-down transistor.

4. The chip according to claim 3, wherein the first passgate transistor and the second passgate transistor are located at the second metal interconnection layer, and the first pull-down transistor and the second pull-down transistor are located at the first metal interconnection layer.

5. The chip according to claim 4, wherein in the same memory cell, a gate of the first pull-up transistor and a gate of the second pull-up transistor are disposed in parallel and spaced apart, the gate of the first pull-up transistor extends towards the second pull-up transistor, the gate of the first pull-up transistor is connected to an electrode of the second pull-up transistor via a first contact structure, the gate of the second pull-up transistor extends towards the first pull-up transistor, and the gate of the second pull-up transistor is connected to an electrode of the first pull-up transistor via a second contact structure.

6. The chip according to claim 5, wherein a gate of the first pull-down transistor and a gate of the second pull-down transistor are disposed in parallel and spaced apart, one end that is of the gate of the first pull-down transistor and that is close to the second pull-down transistor is connected to an electrode of the second pull-down transistor via a third contact structure, and one end that is of the gate of the second pull-down transistor and that is close to the first pull-down transistor is connected via a fourth contact structure.

7. The chip according to claim 6, wherein an electrode of the first passgate transistor is connected to the fourth contact structure via a sixth contact structure, the fourth contact structure is further connected to the second contact structure, and a first storage node comprises the sixth contact structure, the fourth contact structure, and the second contact structure; and an electrode of the second passgate transistor is connected to the third contact structure via a seventh contact structure, the third contact structure is further connected to the first contact structure, and a second storage node comprises the seventh contact structure, the third contact structure, and the first contact structure.

8. The chip according to claim 4, wherein gates of first passgate transistors in the plurality of memory cells are of an integrated structure, gates of second passgate transistors in the plurality of memory cells are of an integrated structure, and in the plurality of memory cells, a gate of at least one first passgate transistor and a gate of at least one second passgate transistor are connected, and are connected to a word line.

9. The chip according to claim 4, wherein in the same memory cell, a gate of the first passgate transistor and a gate of the second passgate transistor are disposed in parallel and spaced apart, a first connection portion is further disposed at the second metal interconnection layer, one end that is of the gate of the first passgate transistor and that is close to the second passgate transistor is connected, via the first connection portion, to one end that is of the gate of the second passgate transistor and that is close to the first passgate transistor, and the first connection portion is connected to a word line.

10. The chip according to claim 4, wherein in the same memory cell, a gate of the first passgate transistor and a gate of the second passgate transistor are of an integrated structure, a second connection portion is further disposed at the second metal interconnection layer, the second connection portion is located between the first passgate transistor and the second passgate transistor, the second connection portion is connected to the gate of the first passgate transistor, and the second connection portion is connected to a word line.

11. The chip according to any one of claims 8 to 10, wherein the word line is disposed on a side that is of the second metal interconnection layer and that is away from the substrate.

12. The chip according to claim 3, wherein the first passgate transistor and the first pull-down transistor are located at the first metal interconnection layer, and the second passgate transistor and the second pull-down transistor are located at the second metal interconnection layer.

13. The chip according to claim 12, wherein an electrode of the first passgate transistor and an electrode of the first pull-down transistor that are close to each other are of an integrated structure, and an electrode of the second passgate transistor and an electrode of the second pull-down transistor that are close to each other are of an integrated structure.

14. The chip according to any one of claims 3 to 13, wherein one electrode of the first pull-up transistor and one electrode of the second pull-up transistor are connected to a first power supply line, the other electrode of the first pull-up transistor is connected to the gate of the second pull-up transistor, and the other electrode of the second pull-up transistor is connected to the gate of the first pull-up transistor; the gate of the first pull-up transistor is further connected to one electrode of the second pull-down transistor, the other electrode of the second pull-down transistor is connected to a second power supply line, the gate of the second pull-down transistor is further connected to the gate of the second pull-up transistor, one electrode of the first pull-down transistor is connected to the gate of the second pull-up transistor, the other electrode of the first pull-down transistor is connected to the second power supply line, and the gate of the first pull-down transistor is connected to the gate of the first pull-up transistor; the gate of the first pull-down transistor is further connected to one electrode of the second passgate transistor, the other electrode of the second passgate transistor is connected to a bit line bar, and the gate of the second passgate transistor is connected to the word line; and one electrode of the first passgate transistor is connected to the gate of the second pull-down transistor, the other electrode of the first passgate transistor is connected to a bit line, and the gate of the first passgate transistor is also connected to the word line.

15. The chip according to any one of claims 1 to 14, wherein the metal interconnection layer comprises a plurality of first dielectric layers and a plurality of second dielectric layers that are alternately stacked, and a dielectric constant of the first dielectric layer is less than a dielectric constant of the second dielectric layer.

16. The chip according to any one of claims 1 to 15, wherein the pull-up transistor comprises a P-type transistor, and the passgate transistor and the pull-down transistor comprise N-type transistors.

17. The chip according to any one of claims 1 to 16, wherein a material of the substrate comprises silicon, and the pull-up transistor comprises a silicon field-effect transistor.

18. An electronic device, comprising a mainboard and the chip according to any one of claims 1 to 17, wherein the chip is disposed on the mainboard.

19. A chip manufacturing method, comprising:
manufacturing, by using a front-end-of-line process on a substrate, a component layer and a pull-up transistor located at the component layer, wherein the component layer comprises a logic circuit; and
forming, by using a back-end-of-line process in a stacked manner on the component layer, a metal interconnection layer, and a passgate transistor and a pull-down transistor that are located at the metal interconnection layer, wherein a static random access memory comprises the passgate transistor, the pull-up transistor, and the pull-down transistor.

20. The chip manufacturing method according to claim 19, wherein forming, by using the back-end-of-line process in the stacked manner on the component layer, the metal interconnection layer, and the passgate transistor and the pull-down transistor that are located at the metal interconnection layer comprises:
forming a first metal interconnection layer and a second metal interconnection layer by using the back-end-of-line process in the stacked manner on the component layer, wherein the first metal interconnection layer is located between the second metal interconnection layer and the component layer, and the passgate transistor and the pull-down transistor are disposed at the first metal interconnection layer and the second metal interconnection layer.

21. The chip manufacturing method according to claim 20, wherein the passgate transistor comprises a first passgate transistor and a second passgate transistor, the pull-up transistor comprises a first pull-up transistor and a second pull-up transistor, and the pull-down transistor comprises a first pull-down transistor and a second pull-down transistor; and the static random access memory comprises a memory cell, the memory cell is configured to store data, the memory cell is a 6T memory cell, and the memory cell comprises: the first passgate transistor, the second passgate transistor, the first pull-up transistor, the second pull-up transistor, the first pull-down transistor, and the second pull-down transistor; and
forming the first metal interconnection layer and the second metal interconnection layer by using the back-end-of-line process in the stacked manner on the component layer comprises:
forming, by using the back-end-of-line process in the stacked manner on the component layer, the first metal interconnection layer, and the first pull-down transistor and the second pull-down transistor that are located at the first metal interconnection layer; and
forming, by using the back-end-of-line process in the stacked manner on the first metal interconnection layer, the second metal interconnection layer, and the first passgate transistor and the second passgate transistor that are located at the second metal interconnection layer.

22. The chip manufacturing method according to claim 20, wherein the passgate transistor comprises a first passgate transistor and a second passgate transistor, the pull-up transistor comprises a first pull-up transistor and a second pull-up transistor, and the pull-down transistor comprises a first pull-down transistor and a second pull-down transistor; and the static random access memory comprises a memory cell, the memory cell is configured to store data, the memory cell is a 6T memory cell, and the memory cell comprises: the first passgate transistor, the second passgate transistor, the first pull-up transistor, the second pull-up transistor, the first pull-down transistor, and the second pull-down transistor; and
forming the first metal interconnection layer and the second metal interconnection layer by using the back-end-of-line process in the stacked manner on the component layer comprises:
forming, by using the back-end-of-line process in the stacked manner on the component layer, the first metal interconnection layer, and the first pull-down transistor and the first passgate transistor that are located at the first metal interconnection layer; and
forming, by using the back-end-of-line process in the stacked manner on the first metal interconnection layer, the second metal interconnection layer, and the second pull-down transistor and the second passgate transistor that are located at the second metal interconnection layer.
